(19) Europäisches Patentamt / European Patent Office / Office européen des brevets

(11) **EP 3 429 859 B1**

(12) **EUROPÄISCHE PATENTSCHRIFT**

(45) Veröffentlichungstag und Bekanntmachung des Hinweises auf die Patenterteilung:
**07.07.2021 Patentblatt 2021/27**

(21) Anmeldenummer: **17710858.6**

(22) Anmeldetag: **10.03.2017**

(51) Int Cl.:
***B41J 2/175*** *(2006.01)* ***B01J 20/22*** *(2006.01)*
***H01L 51/00*** *(2006.01)*

(86) Internationale Anmeldenummer:
**PCT/EP2017/055641**

(87) Internationale Veröffentlichungsnummer:
**WO 2017/157783 (21.09.2017 Gazette 2017/38)**

(54) **DRUCKERKARTUSCHE UMFASSEND EINE FORMULIERUNG ENTHALTEND MINDESTENS EINEN ORGANISCHEN HALBLEITER**

PRINTER CARTRIDGE COMPRISING A FORMULATION CONTAINING AT LEAST ONE ORGANIC SEMICONDUCTOR

CARTOUCHE POUR UNE IMPRIMANTE COMPRENANT UNE FORMULATION CONTENANT AU MOINS UN SEMICONDUCTEUR ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.03.2016 DE 102016003104**

(43) Veröffentlichungstag der Anmeldung:
**23.01.2019 Patentblatt 2019/04**

(73) Patentinhaber: **Merck Patent GmbH**
**64293 Darmstadt (DE)**

(72) Erfinder:
- **HILARIUS, Volker**
  **64823 Gross-Umstadt (DE)**
- **BOEHM, Edgar**
  **64347 Griesheim (DE)**
- **SUERMANN, Juliane**
  **64285 Darmstadt (DE)**
- **GOULDING, Mark**
  **Ringwood BH24 1SH (GB)**
- **GARCIA DIEZ, Leticia**
  **64287 Darmstadt (DE)**

(56) Entgegenhaltungen:
**CN-A- 103 956 407** **JP-A- 2004 149 765**
**US-A1- 2011 175 078** **US-A1- 2014 319 181**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 429 859 B1

## Beschreibung

Die vorliegende Erfindung betrifft eine Druckerkartusche umfassend eine Formulierung enthaltend mindestens einen organischen Halbleiter sowie eine Verwendung derselben.

In der gedruckten Elektronik werden empfindliche organische und anorganische Komponenten eingesetzt und mit Druckverfahren auf Trägermaterialen aufgebracht. In besonderem Maße werden hier hochauflösende Druckverfahren wie Inkjet Printing, Siebdruck, Tampondruck oder auch andere Hoch- und Tiefdruckverfahren eingesetzt. Für diese Druckverfahren ist die Bereitstellung von Drucktinten oder Druckpasten in geeigneten auswechselbaren Vorratsbehältern und Kartuschen üblich. Dazu werden üblicherweise Metall- oder Kunststoffgefäße verwendet, die zum Schutz der empfindlichen Materialien häufig noch zusätzlich mehrlagige Inliner-Beutel enthalten. Durch die Inliner-Beutel wird eine luftüberstandsfreie Befüllung und Entleerbarkeit erreicht und das Material durch die Mehrlagenfolie des Beutels zusätzlich vor Diffusion von Luftsauerstoff, Wasser und/oder anderen Verunreinigungen geschützt.

Allerdings zeigen die so verpackten Drucktinten eine begrenzte Haltbarkeit, wobei die Qualität der Tinten erst am hiermit erzeugten Produkt festgestellt werden kann. Problematisch ist hierbei insbesondere, dass bestimmte Chargen oder Behälter zu einer geringen Qualität der hergestellten elektronischen Vorrichtungen führt, während andere Patronen, die über einen ähnlichen langen Zeitraum gelagert oder transportiert wurden, eine akzeptable Qualität der hergestellten elektronischen Vorrichtungen aufweisen.

In der JP 2004/149765 A1 wird eine Tinten-Kartusche offenbart, die ein Gehäuse und in diesem Gehäuse eine wässrige Ink-Jet Tinte aufweist, wobei die wässrige Ink-Jet Tinte ein Lösungsmittel ausgewählt aus Wasser, einem hydrophilen Lösungsmittel und Gemischen derselben, ein dendritisch, verzweigtes Molekül, das als Bindemittel dient und in einer Menge von 0,5 Gew.-% oder mehr in der wässrigen Tinte enthalten ist, ein Farbmittel und einen oberflächenaktiven Stoff aufweist.

Aufgabe der vorliegenden Erfindung war es daher, Druckerkartuschen, bereitzustellen, in denen die enthaltene Formulierung vor einem vorzeitigen Qualitätsabbau, beispielsweise vor Verunreinigungen, die in die Druckerkartuschen eindringen können, geschützt werden. Eine weitere Aufgabe bestand darin, die Sicherheit und die Zuverlässigkeit von Druckerkartuschen, enthaltend mindestens einen organischen Halbleiter, dahingehend zu erhöhen, dass die Tinten auch nach einer längeren Lagerzeit zu einer hohen Qualität der hergestellten elektronischen Vorrichtungen führen.

Überraschend wurde festgestellt, dass der Qualtitäsabbau von Formulierung enthaltend mindestens einen organischen Halbleiter stark durch die Verwendung von mindestens einem Absorptionsmaterial, das mit der Formulierung in Kontakt steht, herabgesetzt werden kann. Hierdurch können Drucktinten lange gelagert und transportiert werden, ohne dass die Qualität der durch diese Tinten erhaltenen eletronischen Vorrichtungen herabgesetzt werden würde. Weiterhin weisen die erfindungsgemäßen Druckerkartuschen eine hohe Zuverlässigkeit auf.

Gegenstand der vorliegenden Erfindung ist somit eine Druckerkartusche umfassend eine Formulierung enthaltend einen oder mehrere organische Halbleiter gelöst oder dispergiert in einem organischen Lösungsmittel oder Dispergiermittel, wobei die Formulierung mit mindestens einem Absorptionsmaterial in Kontakt steht und das Absorptionsmaterial Sauerstoff, Wasser, Kohlendioxid und/oder Hydroxidionen binden oder mit diesen Stoffen reagieren kann, dadurch gekennzeichnet, dass die Druckerkartusche ein Gehäuse aufweist, in das ein Innenbeutel eingebracht ist, in welchem sich die Formulierung, enthaltend mindestens einen organischen Halbleiter, befindet.

Der Begriff Drucktinten bzw. Tinten umfasst in der vorliegenden Anmeldung auch Druckpasten. Anstelle der Begriffe Drucktinte bzw. Tinte wird in der vorliegenden Anmeldung synonym auch der Begriff Lösung bzw. Formulierung verwendet.

Der zur Aufnahme einer Formulierung gewählte Druckerkartusche unterliegt keiner besonderen Begrenzung und kann daher zum Transport, zur Lagerung und/oder zur Verwendung als Kartusche ausgestaltet sein. Wesentlich ist hierbei, dass die Durchlässigkeit gegenüber Substanzen, die zu einer Beeinträchtigung der Qualität der Formulierung führen können, möglichst gering sein sollte. Vorzugsweise ist der Druckerkartusche als Druckerpatrone ausgebildet und kann demgemäß in einen passend gestalteten Drucker eingesetzt werden.

Die Größe, Form und Ausgestaltung des erfindungsgemäßen Tinten-Vorratsbehälters bzw. der erfindungsgemäßen Tinten-Kartusche ist demgemäß in keiner Weise beschränkt. Vielmehr können erfindungsgemäß alle bekannten Druckerkartuschen verwendet werden, die für die Aufbewahrung der erfindungsgemäß eingesetzten Tinten, das heißt Formulierungen, die mindestens einen organischen Halbleiter in mindestens einem Lösungsmittel enthalten, geeignet sind.

Als Absorptionsmaterial für die erfindungsgemäß eingesetzten Formulierungen eignen sich sämtliche Materialien, die Sauerstoff, Wasser, Kohlendioxid und/oder andere Verunreinigungskomponenten, beispielsweise Hydroxidionen absorbieren und/oder chemisch binden können. Bevorzugt als Absorptionsmaterialen, hierin auch als Getter-Materialien bezeichnet, für die erfindungsgemäß eingesetzten Formulierungen sind Verbindungen, die im Temperaturbereich von -40°C bis 200°C, vorzugsweise in einem Temperaturbereich von 10°C bis 50°C, besonders bevorzugt bei Raum- und damit Lagertemperatur, hydrolysieren, Wasser, Kohlendioxid oder Sauerstoff absorbieren und/oder sich unter Aufnahme von Wasser, Sauerstoff, Halogenen und/oder Kohlendioxid zersetzen oder chemisch umwandeln.

Vorzugsweise kann vorgesehen sein, dass die Absorptions- und/oder Reaktionsgeschwindigkeit des Absorptionsmaterials mit Sauerstoff, Wasser, Kohlendioxid und/oder Hydroxidionen wesentlich höher ist als die Reaktionsgeschwindigkeit von Sauerstoff, Wasser, Kohlendioxid und/oder Hydroxidionen mit dem in der Formulierung enthaltenen organischen Halbleiter.

Besonders bevorzugt als Getter-Materialien sind Alkali- oder Erdalkalimetalle, wie z.B. Ca, Ba, Sr, Mg, Li, Na und K, oder deren Oxide, Aluminium-, Titan- oder Zirconiumoxid, Siliciumoxid, hochporöse oder nanopartikuläre Oxide, Zeolithe, Silicagele oder Alumino-Silikate, Übergangsmetalle, wie z.B. Zirconium, Vanadium, Cobalt, Eisen, Mangan, Kupfer und Zink, oder deren Oxide, sowie Kombinationen, Mischungen oder Legierungen aus diesen Materialien, wie z.B. Silicagele, die mit Alkalioder Erdalkalimetallen angereichert sind. Die genannten Absorptionsmaterialien können einzeln oder als Mischung von 2, 3, 4 oder mehr eingesetzt werden. So können unter anderem Materialien verwendet werden, die als Getter zur Erzeugung von Vakuum eingesetzt werden, wobei beispielhaft die Legierungen St 707 (70% Zirconium, 24,6% Vanadium und 5,6% Eisen), St 787 (80,8% Zirconium, 14,2% Cobalt und 5,0% Cer-Mischmetall) und St 101 (84% Zirconium und 16% Aluminium) genannt werden können.

Die Einbringung des mindestens einen Absorptionsmaterials in die erfindungsgemäß einzusetzenden Druckerkartuschen kann dabei auf jede bekannten Art und Weise erfolgen. Beispielsweise kann das Absorptionsmaterial in Form einer Folie, eines Pulvers, eines Granulats, vorzugsweise mit Korngrößen im Bereich von 1 $\mu$m bis 5 mm, besonders bevorzugt 100 $\mu$m bis 1 mm, und/oder eines Formkörpers, vorzugsweise eines Blechs, einer Stäbchens oder einer Tablette vorliegen. Hierbei kann das Absorptions-material massiv, porös oder partikulär sein. Die Dimension der Folie oder des Formkörpers kann entsprechend den Anforderungen gewählt werden, wobei diese vorzugsweise größer oder gleich 1 mm, besonders bevorzugt größer oder gleich 10 mm in der größten Ausdehnung beträgt.

Das Absorptionsmaterial steht in Kontakt mit der Formulierung enthaltend mindestens einen organischen Halbleiter. Hierbei kann das vorgesehen sein, dass das Absorptionsmaterial unmittelbar mit der Formulierung in Kontakt steht. Unmittelbar bedeutet hierin, dass die Oberfläche des Absorptionsmaterials direkt in Kontakt mit der Formulierung steht, also nicht umhüllt oder in ein Behältnis eingebracht ist. Demgemäß kann das Absorptionsmaterial unmittelbar der Formulierung zugegeben werden.

Überraschende Vorteile können dadurch erzielt werden, dass das Absorptionsmaterial in ein Polymermaterial, vorzugsweise einen Polymerfilm oder eine Polymerbeschichtung eingebettet ist. Durch diese Ausgestaltung kann überraschend die Transportfähigkeit der Druckerkartuschen unter Beibehaltung der Qualtität der Formulierung gesteigert werden. Insbesondere können diese Druckerkartuschen auch zur Aufbewahrung und zum Transport von Tinten eingesetzt werden, die zur Herstellung von hochauflösenden Bildschirmen und feinstrukturierter Elektronik geeignet sind. So zeigen die in den Druckerkartuschen aufbewahrten Tinten auch nach einem Transport einen überraschend geringen Feinanteil, der zu einer Beeinträchtigung der aus den Formulierungen erhaltenen elektronischen Vorrichtungen führen kann.

Die Art und Weise der Einbettung des Absorptionsmaterials in das Polymermaterial unterliegt keiner besonderen Begrenzung. Je nach Anforderung kann das Polymermaterial, vorzugsweise der Polymerfilm das Absorptionsmaterial enthalten, so dass eine Mischung aus Polymermaterial und Absorptionsmaterial vorliegt. Bevorzugt kann das Absorptionsmaterial homogen in dem Polymermaterial, vorzugsweise dem Polymerfilm verteilt sein. Durch diese Ausgestaltung kann eine leichte Dosierung und Handhabung des Absorptionsmaterials erzielt werden.

Ferner kann vorgesehen sein, dass das Polymermaterial, vorzugsweise der Polymerfilm das Absorptionsmaterial umgibt, so dass der Polymerfilm einen Beutel, einen Behälter oder eine Umhüllung bildet, in welchem das Absorptionsmaterial enthalten ist. Diese Ausgestaltung zeichnet sich durch eine besonders hohe Stabilität gegenüber einer Freisetzung von Partikeln in die Formulierung aus, die auch über einen langen Transport erhalten bleibt. Das Polymermaterial kann hierbei Poren aufweisen, wobei die Poren jedoch möglichst klein gehalten werden sollten, um zu verhindern, dass Partikel des Absorptionsmaterial in die Formulierung gelangen.

Vorzugsweise sind die Poren kleiner als 0,1 $\mu$m, besonders bevorzugt sind im Wesentlichen keine Poren in dem Polymermaterial enthalten.

Darüber hinaus kann eine Mischung aus Polymermaterial und Absorptionsmaterial in einen Beutel, einen Behälter oder eine Umhüllung gegeben werden, so dass eine Kombination aus den zuvor dargelegten Ausführungsformen gegeben ist.

Ferner kann vorgesehen sein, dass das Polymermaterial, vorzugsweise der Polymerfilm bevorzugt eine Dicke im Bereich von 10 nm bis 500 $\mu$m, vorzugsweise im Bereich von 50 nm bis 200 $\mu$m, besonders im Bereich von 0,1 $\mu$m bis 100 $\mu$m aufweist.

Vorzugsweise kann das Polymermaterial, besonders bevorzugt der Polymerfilm eine Durchlässigkeit gegenüber Sauerstoff, Wasser, Kohlendioxid und/oder Hydroxidionen von mindestens 0,001 g/($m^2$ d) (Gramm pro Quadratmeter und Tag) aufweisen, gemessen mittels Diffusionsmessung bei 25°C. Die Meßmethodik ist unter www.mocontesting.com beschrieben und kann beispielsweise gemäß ASTM E96, ASTM E398, ASTM F1249, ASTM D6701, Tappi T557, Tappai T523, ISO 15106, JIS K7129, ASTM D3985, ASTM F1307, ASTM F2622-8 und/oder ASTM F1927 erfolgen, wobei jeweils die zum 11.02.2016 gültige Fassung der Norm Verwendung finden kann.

Ferner kann das vorgesehen sein, dass das Polymermaterial, vorzugsweise der Polymerfilm, ein Polyolefin, bevorzugt Polyethylen (LDPE, HDPE) oder Polypropylen, oder ein fluoriertes Polymer, vorzugsweise Perfluoralkoxy-Polymere (PFA, Teflon), Polyvinylidenfluorid (PVDF, Kynar) oder Polytetrafluorethylen (PTFE) umfasst. Besonders bevorzugt kann beispielsweise ein unter der Bezeichnung Goretex™ erhältliches PTFE eingesetzt werden.

Das Gewichtsverhältnis von Polymermaterial zu Absorptionsmaterial kann in einem weiten Bereich gewählt werden, wobei der Anteil von der Einbringungsart des Absorptionsmaterials sowie den Stabilitätsanforderungen abhängig ist. Bei einer Verbesserung der Dosierung und Handhabung genügen relativ kleine Mengen an Polymermaterial; falls eine Verbesserung der Transportfähigkeit Ziel ist, können größere Anteile an Polymermaterial zweckmäßig sein. Vorzugsweise kann das Gewichtsverhältnis von Absorptionsmaterial zu Polymermaterial, vorzugsweise Polymerfilm im Bereich von 500:1 bis 1:500, vorzugsweise 100:1 bis 1:100, speziell bevorzugt 10:1 bis 1:10 liegen.

In der erfindungsgemäßen Ausgestaltung sind die Druckerkartuschen derart ausgestaltet, dass sie ein Gehäuse aufweisen, in das ein Innenbeutel eingebracht ist, in welchem sich die Formulierung, enthaltend mindestens einen organischen Halbleiter, befindet.

Der in der Druckerkartusche enthaltene Innenbeutel kann aus einer Mehrschichtfolie aufgebaut sein, die gegenüber Sauerstoff, Wasser, Kohlendioxid und/oder Hydroxidionen undurchlässig ist. Undurchlässig bedeutet hierbei, dass die Durchlässigkeit dieser Folien gegenüber Sauerstoff, Wasser und/oder Kohlendioxid kleiner als 0,00001 g/($m^2$ d), vorzugsweise kleiner als $10^{-6}$ g/($m^2$ d) ist, gemessen mittels Diffussionmessungen bei 25°C. Die Undurchlässigkeit einer Mehrschichtfolie kann insbesondere durch die Verwendung eines Metallfilms erreicht werden, der vorzugsweise eine Dicke im Bereich von 20 $\mu$m bis 100 $\mu$m, besonders bevorzugt 40 $\mu$m bis 60 $\mu$m aufweisen kann.

Ferner kann vorgesehen sein, dass der Innenbeutel, der in der Druckerkartusche enthalten ist, Strukturen aufweist, die eine vollständige Entleerung des Innenbeutels sicherstellen. Diese Strukturen können beispielsweise durch Verschweißungsstellen erzeugt werden.

In einer besonderen Ausgestaltung kann zumindest auf einen Teil der inneren Oberfläche des Innenbeutels eine Schicht mit einem Absorptionsmaterial aufgebracht und/oder das Absorptionsmaterial in eine Innenschicht des Innenbeutels eingebracht werden.

Ferner kann das Absorptionsmaterial Bestandteil einer Schicht des Beutels sein, auf die eine weitere Schicht aufgebracht wird, so dass zwischen dem Absorptionsmaterial und der Formulierung eine Schicht des Innenbeutels vorgesehen ist, die kein Absorptionsmaterial umfasst. Hierbei sollte diese Schicht gegenüber den zu absorbierenden Stoffen eine hohe Durchlässigkeit aufweisen.

Weiterhin kann vorgesehen sein, dass die Druckerkartusche ein Ventil aufweist, wobei das Absorptionsmaterial in der Nähe des Ventils fixiert ist. Hierbei kann das Absorptionsmaterial vorzugsweise in einen Polymerfilm, einen Beutel, einen Behälter oder eine Umhüllung eingebracht werden, der bzw. die mit dem Ventil verbunden ist, vorzugsweise verschweißt ist. Durch diese Ausgestaltung kann eine besonders einfache und zweckmäßige Einbringung des Absorptionsmaterials sichergestellt werden.

Eine erfindungsgemäße Druckerkartusche umfasst eine Formulierung, wobei die Formulierung eine Lösung, eine Dispersion oder eine Suspension darstellen kann, in der ein oder mehrere organische Halbleiter in einem Lösungsmittel oder Dispergiermittel gelöst oder dispergiert sind.

Hierbei kann die Formulierung übliche Lösungs- oder Dispergiermittel enthalten, die jeweils in Abhängigkeit der organischen Halbleiter sowie dem Druckverfahren gewählt werden.

So kann die Formulierung ein Lösungsmittel oder Dispergiermittel umfassen, welches ausgewählt ist aus Alkoholen, Aldehyden, Ketonen, Ethern, Estern, Amiden, Schwefelverbindungen, Nitroverbindungen, Kohlenwasserstoffen, halogenierten Kohlenwasserstoffen, aromatischen oder heteroaromatischen Kohlenwasserstoffen, halogenierten aromatischen oder heteroaromatischen Kohlenwasserstoffen, Siloxanen sowie Mischungen dieser Verbindungen, vorzugsweise Ketone, Ester, Amide, Schwefelverbindungen, Nitroverbindungen, halogenierte Kohlenwasserstoffe und Kohlenwasserstoffe. Aromatische und heteroaromatische Kohlenwasserstoffe, Di-$C_{1-2}$-alkyl formamide, und chlorierte Kohlenwasserstoffe sind besonders bevorzugte organische Lösungsmittel.

Besonders bevorzugte organische Lösungsmittel oder Dispergiermittel sind beispielsweise 1,2,3,4-Tetramethylbenzol, 1,2,3,5-Tetramethylbenzol, 1,2,3-Trimethylbenzol, 1,2,4,5-Tetramethylbenzol, 1,2,4-Trichlorbenzol, 1,2,4-Trimethylbenzol, 1,2-Dihydronaphthalin, 1,2-Dimethylnaphthalin, 1,3-Benzodioxolan, 1,3-Diisopropylbenzol, 1,3-Dimethylnaphthalin, 1,4-Benzodioxan, 1,4-Diisopropylbenzol, 1,4-Dimethylnaphthalin, 1,5-Dimethyltetralin, 1-Benzothiophen, Thianaphthalin, 1-Bromnaphthalin, 1-Chlormethyl-Naphthalin, 1-Ethyl-Naphthalin, 1-Methoxy-Naphthalin, 1-Methylnaphthalin, 1-Methylindol, 2,3-Benzofuran, 2,3-Dihydrobenzofuran, 2,3-Dimethylanisol, 2,4-Dimethylanisol, 2,5-Dimethylanisol, 2,6-Dimethylanisol, 2,6-Dimethylnaphthalin, 2-Brom-3-Brommethylnaphthalin, 2-Brommethylnaphthalin, 2-Bromnaphthalin, 2-Ethoxynaphthalin, 2-Ethylnaphthalin, 2-Isopropylanisol, 2-Methylanisol, 2-Methyl-indol, 3,4-Dimethylanisol, 3,5-Dimethylanisol, 3-Bromchinolin, 3-Methylanisol, 4-Methylanisol, 5-Decanolide, 5-Methoxyindan, 5-Methoxyindole, 5-tert-Butylm-Xylol, 6-Methylchinolin, 8-Methylchinolin, Acetophenon, Anisol, Benzonitril, Benzothiazol, Benzylacetat, Brombenzol, Butylbenzoat, Butylphenylether, Cyclohexylbenzol, Decahydronaphthol, Dimethoxytoluol, Diphenylether, Propiophenon, Ethylbenzol, Ethylbenzoat, $\gamma$-Terpinen, Hexylbenzol, Indan, Inden, Isochroman, Cumol,

m-Cymol, Mesitylen, Methylbenzoat, o-, m-, p-Xylol, Propylbenzoat, Propylbenzol, o-Dichlorbenzol, Pentylbenzol, Phenetol, Ethoxybenzol, Phenylacetat, p-Cymol, Propiophenon, sec-Butylbenzol, t-Butylbenzol, Thiophen, Toluol, Veratrol, Monochlorbenzol, o-Dichlorbenzol, Pyridine, Pyrazine, Pyrimidine, Pyrrolidinone, Morpholin, Dimethylacetamid, Dimethylsulfoxid, Decalin, Phenoxytoluol, insbesondere 3-Phenoxytoluol, Tetrahydrofuran (THF), Methyl-THF, Tetrahydropyran (THP), Cyclohexanon und/oder Mischungen dieser Verbindungen.

Die Lösungsmittel oder Dispergiermittel können einzeln oder als Mischung von zwei, drei oder mehreren Verbindungen eingesetzt werden. Vorzugsweise kann das Absorptionsmaterial entsprechend dem eingesetzten Lösungsmittel oder Dispergiermittel gewählt werden, so dass keine Reaktion zwischen Lösungsmittel oder Dispergiermittel und Absorptionsmaterial eintritt. Gegebenenfalls kann das Absorptionsmaterial so umhüllt oder eingebettet werden, dass dieses vom Lösungsmittel oder Dispergiermittel getrennt wird.

Ferner umfasst eine erfindungsgemäß einsetzbare Formulierung mindestens einen organischen Halbleiter, der vorzugsweise ausgewählt ist aus Host-Materialien, Matrix-Materialien, Elektronentransportmaterialien, Elektroneninjektionsmaterialien, Lochleitermaterialien, Lochinjektionsmaterialien, Elektronenblockiermaterialien und Lochblockiermaterialien.

Das organische Halbleitermaterial kann eine Verbindung mit einem geringen Molekulargewicht, ein Polymer, ein Oligomer oder ein Dendrimer sein, wobei das organische Halbleitermaterial auch als Mischung vorliegen kann. So können die erfindungsgemäß einsetzbaren Formulierungen zwei unterschiedliche Verbindungen mit einem geringen Molekulargewicht umfassen, eine Verbindung mit einem geringen Molekulargewicht und ein Polymer oder zwei Polymere (Blend).

Organische Halbleitermaterialien werden vielfach über die Eigenschaften der Grenzorbitale beschrieben, die nachfolgend näher dargelegt werden. Molekülorbitale, insbesondere auch das highest occupied molecular orbital (HOMO) und das lowest unoccupied molecular orbital (LUMO), deren Energieniveaus sowie die Energie des niedrigsten Triplettzustands $T_1$ bzw. des niedrigsten angeregten Singulettzustands $S_1$ der Materialien werden über quantenchemische Rechnungen bestimmt. Zur Berechnung organischer Substanzen ohne Metalle wird zuerst eine Geometrieoptimierung mit der Methode "Ground State/Semi-empirical/Default Spin/AM1/Charge 0/Spin Singlet" durchgeführt. Im Anschluss erfolgt auf Grundlage der optimierten Geometrie eine Energierechnung. Hierbei wird die Methode "TD-SCF/DFT/Default Spin/B3PW91" mit dem Basissatz "6-31 G(d)" verwendet (Charge 0, Spin Singlet). Für metallhaltige Verbindungen wird die Geometrie über die Methode "Ground State/ Hartree-Fock/Default Spin/LanL2MB/Charge 0/Spin Singlet" optimiert. Die Energierechnung erfolgt analog zu der oben beschriebenen Methode für die organischen Substanzen mit dem Unterschied, dass für das Metallatom der Basissatz "LanL2DZ" und für die Liganden der Basissatz "6-31 G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$\mathrm{HOMO(eV)} = ((\mathrm{HEh}*27.212)-0.9899)/1.1206$$

$$\mathrm{LUMO(eV)} = ((\mathrm{LEh}*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

Die hierin beschriebene Methode ist unabhängig von dem verwendeten Softwarepaket und liefert immer dieselben Ergebnisse. Beispiele oft benutzter Programme für diesen Zweck sind "Gaussian09W" (Gaussian Inc.) und Q-Chem 4.1 (Q-Chem, Inc.).

Verbindungen mit Lochinjektionseigenschaften, hierin auch Lochinjektionsmaterialien genannt, erleichtern oder ermöglichen die Übertragung von Löchern, d.h. positive Ladungen, aus der Anode in eine organische Schicht. Im Allgemeinen weist ein Lochinjektionsmaterial ein HOMO-Niveau auf, das im Bereich des Niveaus der Anode ist oder darüber liegt, d.h. im Allgemeinen mindestens -5,3 eV beträgt.

Verbindungen mit Lochtransporteigenschaften, hierin auch Lochtransportmaterialien genannt, sind in der Lage Löcher, d.h. positive Ladungen, zu transportieren, die im Allgemeinen aus der Anode oder einer angrenzenden Schicht, beispielsweise einer Lochinjektionsschicht injiziert werden. Ein Lochtransportmaterial weist im Allgemeinen ein hohes HOMO-Niveau von vorzugsweise mindestens -5.4 eV auf. Je nach Aufbau einer elektronischen Vorrichtung kann ein Lochtransportmaterial auch als Lochinjektionsmaterial eingesetzt werden.

Zu den bevorzugten Verbindungen, die Lochinjektions- und/oder Lochtransporteigenschaften aufweisen, gehören beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-paradioxin-, Phenoxathiin-, Carbazol-, Azulen-, Thiophen-, Pyrrol- und Furanderivate und weitere O-, S- oder N-haltige Heterocyclen mit hoch liegendem HOMO (HOMO = höchstes besetztes Molekülorbital).

Insbesondere zu nennen sind als Verbindungen, die Lochinjektionsund/oder Lochtransporteigenschaften aufweisen, Phenylendiamin-Derivate (US 3615404), Arylamin-Derivate (US 3567450), Amino-substituierte Chalcon-Derivate (US 3526501), Styrylanthracen-Derivate (JP-A-56-46234), Polyzyklische aromatische Verbindungen (EP 1009041), Polyarylalkan-Derivate (US 3615402), Fluorenon-Derivate (JP-A-54-110837), Hydrazon-Derivate (US 3717462), Acylhydrazone, Stilben-Derivate (JP-A-61-210363), Silazan-Derivate (US 4950950), Polysilane (JP-A-2-204996), Anilin-Copolymere (JP-A-2-282263), Thiophen-Oligomere (JP Heisei 1 (1989) 211399), Polythiophene, Poly(N-vinylcarbazol) (PVK), Polypyrrole, Polyaniline und andere elektrisch leitende Makromoleküle, Porphyrin-Verbindungen (JP-A-63-2956965, US 4720432), aromatische Dimethyliden-Typ-Verbindungen, Carbazol-Verbindungen wie z.B. CDBP, CBP, mCP, aromatische tertiäre Amin- und Styrylamin-Verbindungen (US 4127412) wie z.B. Triphenylamine vom Benzidin-Typ, Triphenylamine vom Styrylamin-Typ und Triphenylamine vom Diamin-Typ. Auch Arylamin-Dendrimere können verwendet werden (JP Heisei 8 (1996) 193191), monomere Triarylamine (US 3180730), Triarylamine mit einem oder mehreren Vinylradikalen und/oder mindestens einer funktionellen Gruppe mit aktivem Wasserstoff (US 3567450 und US 3658520) oder Tetraaryldiamine (die zwei Tertiäramineinheiten sind über eine Arylgruppe verbunden). Es können auch noch mehr Triarylamino-gruppen im Molekül vorhanden sein. Auch Phthalocyanin-Derivate, Naphthalocyanin-Derivate, Butadien-Derivate und Chinolinderivate wie z.B. Dipyrazino[2,3-f:2',3'-h]quinoxalinhexacarbonitril sind geeignet.

Bevorzugt sind aromatische tertiäre Amine mit mindestens zwei Tertiäramin-Einheiten (US 2008/0102311 A1, US 4720432 und US 5061569), wie z.B. NPD ($\alpha$-NPD = 4,4'-bis[N-(1-naphthyl)-N-phenylamino]biphenyl) (US 5061569), TPD 232 (= N,N'-Bis-(N,N'-diphenyl-4-aminophenyl)-N,N-diphenyl-4,4'-diamino-1,1'-biphenyl) oder MTDATA (MTDATA oder m-MTDATA= 4,4',4"-Tris[3-methylphenyl)phenylamino]triphenylamin) (JP-A-4-308688), TBDB (= N,N,N',N'-Tetra(4-biphenyl)diaminobiphenylen), TAPC (= 1,1-Bis(4-di-p-tolylaminophenyl)-cyclohexan), TAPPP (= 1,1-Bis(4-di-p-tolylaminophenyl)-3-phenylpropan), BDTAPVB (= 1,4-Bis[2-[4-[N,N-di(p-tolyl)amino]phenyl]vinyl]benzol), TTB (= N,N,N',N'-Tetra-p-tolyl-4,4'-diaminobiphenyl), TPD (= 4,4'-Bis[N-3-methylphenyl]-N-phenylamino)biphenyl), N,N,N',N'-Tetraphenyl-4,4"'diamino-1,1',4',1",4",1"'-quaterphenyl, ebenso tertiäre Amine mit Carbazol-Einheiten wie z.B. TCTA (= 4-(9H-Carbazol-9-yl)-N,N-bis[4-(9H-carbazol-9-yl)phenyl]benzolamin). Ebenfalls bevorzugt sind Hexaaza-Triphenylen-Verbindungen gemäß US 2007/0092755 A1 sowie Phthalocyanin-Derivate (z.B. $H_2Pc$, CuPc (= Kupfer-Phthalocyanin), CoPc, NiPc, ZnPc, PdPc, FePc, MnPc, ClAlPc, ClGaPc, ClInPc, ClSnPc, $Cl_2SiPc$, (HO)AlPc, (HO)GaPc, VOPc, TiOPc, MoOPc, GaPc-O-GaPc).

Besonders bevorzugt sind folgende Triarylamin-Verbindungen gemäß den Formeln (TA-1) bis (TA-12), die in den Dokumenten EP 1162193 B1, EP 650 955 B1, Synth.Metals 1997, 91(1-3), 209, DE 19646119 A1, WO 2006/122630 A1, EP 1 860 097 A1, EP 1834945 A1, JP 08053397 A, US 6251531 B1, US 2005/0221124, JP 08292586 A, US 7399537 B2, US 2006/0061265 A1, EP 1 661 888 und WO 2009/041635 offenbart werden. Die genannten Verbindungen gemäß den Formeln (TA-1) bis (TA-12) können auch substituiert sein:

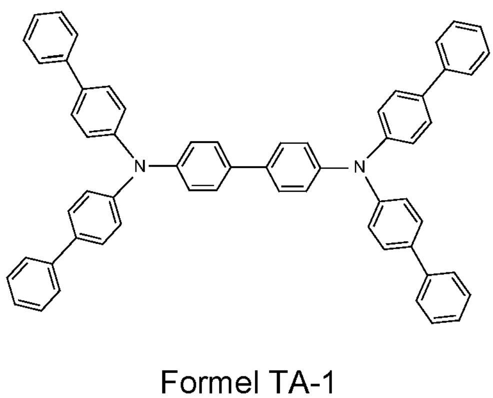

Formel TA-1

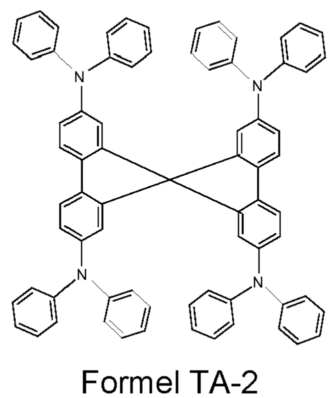

Formel TA-2

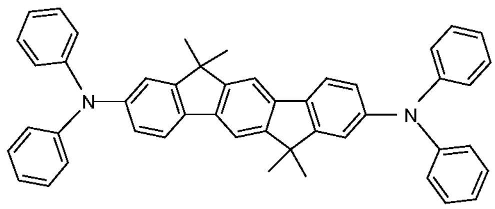

Formel TA-3

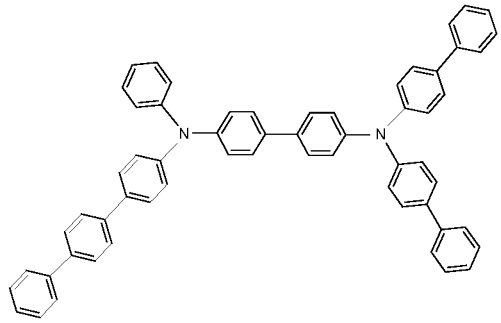

Formel TA-4

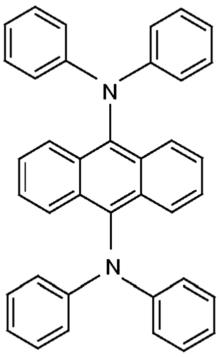

Formel TA-5

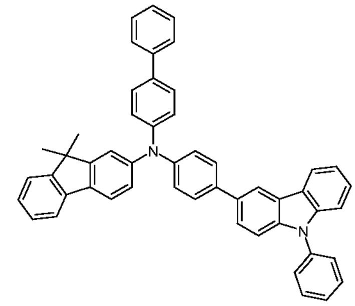

Formel TA-6

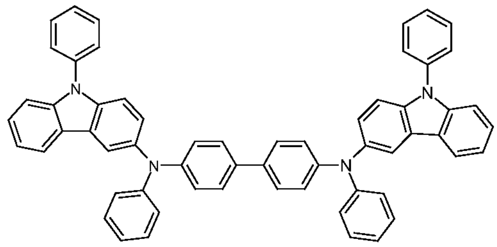

Formel TA-7

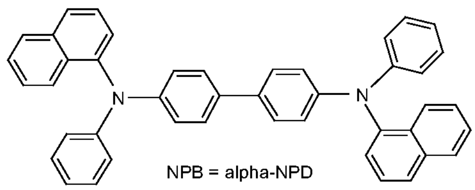

NPB = alpha-NPD

Formel TA-8

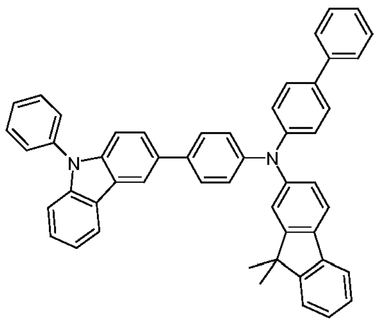

Formel TA-9

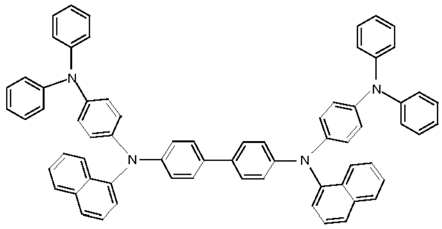

Formel TA-10

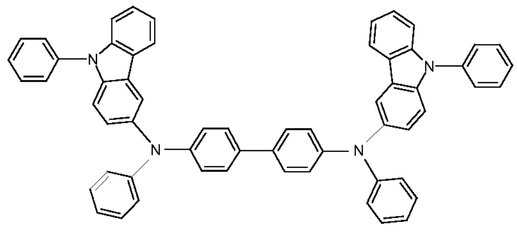

Formel TA-11

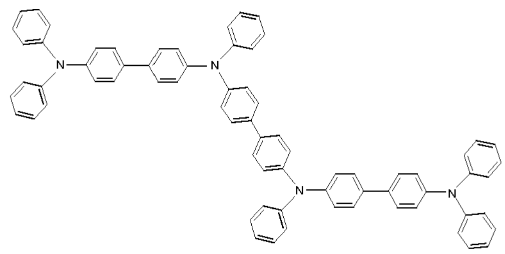

Formel TA-12

Weitere Verbindungen, die als Lochinjektionsmaterialien eingesetzt werden können, sind beschrieben in der EP 0891121 A1 und der EP 1029909 A1, Injektionsschichten allgemein in der US 2004/0174116 A1.

Vorzugsweise führen diese Arylamine und Heterocyclen, die im allgemeinen als Lochinjektions- und/oder Lochtransportmaterialien eingesetzt werden, zu einem HOMO von mehr als -5,8 eV (gegen Vakuumlevel), besonders bevorzugt von mehr als -5,5 eV.

Verbindungen, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital).

Besonders geeignete Verbindungen für elektronentransportierende und elektroneninjizierende Schichten sind Metallchelate von 8-Hydroxychinolin (z.B. LiQ, $AlQ_3$, $GaQ_3$, MgQ2, ZnQ2, $InQ_3$, $ZrQ_4$), BAlQ, Ga-Oxinoid-Komplexe, 4-Azaphenanthren-5-ol-Be-Komplexe (US 5529853 A, vgl. Formel ET-1), Butadienderivate (US 4356429), heterozyklische optische Aufheller (US 4539507), Benzimidazol-Derivate (US 2007/0273272 A1), wie z.B. TPBI (US 5766779, vgl. Formel ET-2), 1,3,5-Triazine, z.B. Spirobifluoren-Triazin-Derivate (z.B. gemäß der DE 102008064200), Pyrene, Anthracene, Tetracene, Fluorene, Spirofluorene, Dendrimere, Tetracene (z.B. Rubren-Derivate), 1,10-Phenanthrolin-Derivate (JP 2003-115387, JP 2004-311184, JP-2001-267080, WO 02/043449), SilaCyclopentadien-Derivate (EP 1480280, EP 1478032, EP 1469533), Boran-Derivate wie z.B. Triarylboranderivate mit Si (US 2007/0087219 A1, vgl. Formel ET-3), Pyridin-Derivate (JP 2004-200162), Phenanthroline, vor allem 1,10-Phenanthrolinderivate, wie z.B. BCP und Bphen, auch mehrere über Biphenyl oder andere aromatische Gruppen verbundene Phenanthroline (US-2007-0252517 A1) oder mit Anthracen verbundene Phenanthroline (US 2007-0122656 A1, vgl. Formeln ET-4 und ET-5).

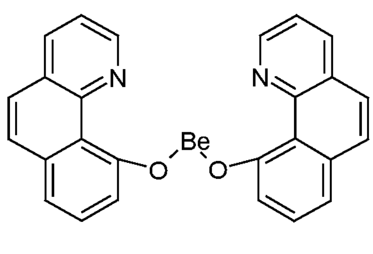

Formel ET-1

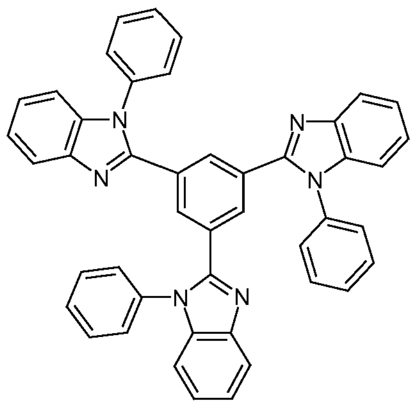

TPBI

2,2',2''-(1,3,5-benzenetriyl)tris(1-phenyl-1H-benzimi

Formel ET-2

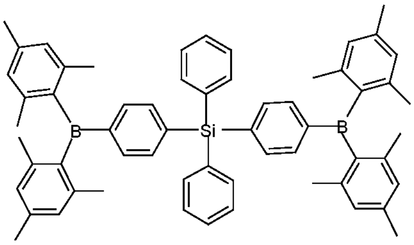

Formel ET-3

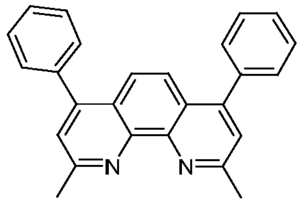

Formel ET-4

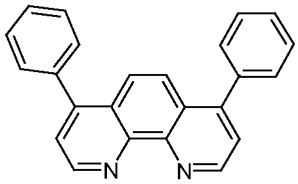

Formel ET-5

Ebenfalls geeignet sind heterozyklische, organische Verbindungen wie z.B. Thiopyrandioxide, Oxazole, Triazole, Imidazole oder Oxadiazole. Beispiele für die Verwendung von Fünfringen mit N wie z.B. Oxazole, vorzugsweise 1,3,4-Oxadiazole, sind beispielsweise Verbindungen gemäß Formeln ET-6, ET-7, ET-8 und ET-9, die unter anderem in der US 2007/0273272 A1 offenbart werden; Thiazole, Oxadiazole, Thiadiazole, Triazole, u.a. siehe US 2008/0102311 A1 und Y.A. Levin, M.S. Skorobogatova, Khimiya Geterotsiklicheskikh Soedinenii 1967 (2), 339-341, vorzugsweise Verbindungen gemäß der Formel ET-10, Silacyclopentadien-Derivate.

Bevorzugte Verbindungen sind folgende gemäß den Formeln (ET-6) bis (ET-10):

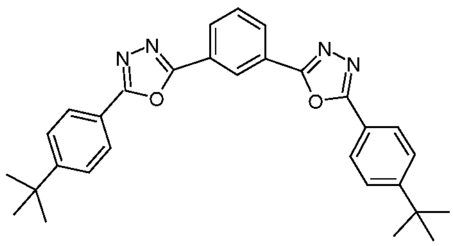

Formel ET-6

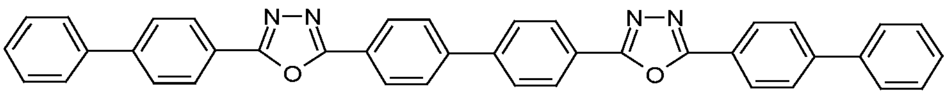

Formel ET-7

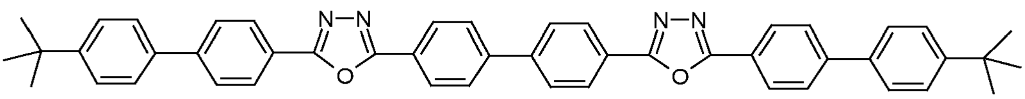

Formel ET-8

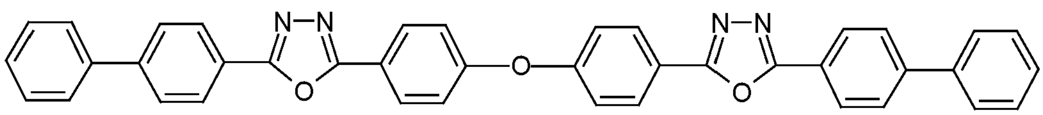

Formel ET-9

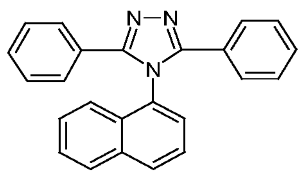

Formel ET-10

Auch organische Verbindungen wie Derivate von Fluorenon, Fluorenylidenmethan, Perylentetrakohlensäure, Anthrachinondimethan, Diphenochinon, Anthron und Anthrachinondiethylendiamin können eingesetzt werden.

Bevorzugt sind 2,9,10-substituierte Anthracene (mit 1- oder 2-Naphthyl und 4- oder 3-Biphenyl) oder Moleküle, die zwei Anthraceneinheiten enthalten (US2008/0193796 A1, vgl. Formel ET-11). Sehr vorteilhaft ist auch die Verbindung von 9,10-substituierten Anthracen-Einheiten mit Benzimidazol-Derivaten (US 2006 147747 A und EP 1551206 A1, vgl. Formeln ET-12 und ET-13).

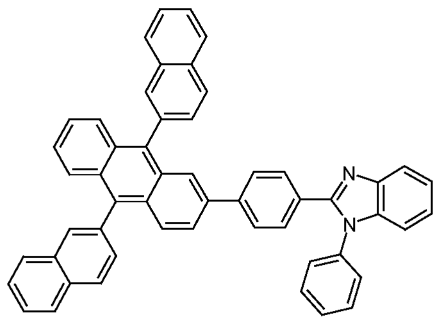

Formel ET-11

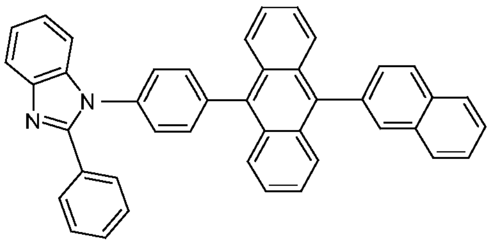

Formel ET-12

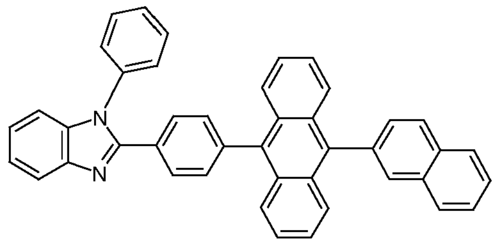

Formel ET-13

Vorzugsweise führen die Verbindungen, die die Elektroneninjektionsund/oder Elektronentransporteigenschaften erzeugen können, zu einem LUMO von weniger als -2,5 eV (gegen Vakuumlevel), besonders bevorzugt von weniger als -2,7 eV.

Die vorliegenden Formulierungen können Emitter umfassen. Der Begriff Emitter bezeichnet ein Material, welches, nach einer Anregung, die durch Übertragung jeder Art von Energie erfolgen kann, einen strahlungsbehafteten Übergang unter Emission von Licht in einen Grundzustand erlaubt. Im Allgemeinen sind zwei Klassen von Emittern bekannt, nämlich fluoreszierende und phosphoreszierende Emitter. Der Begriff fluoreszierender Emitter bezeichnet Materialien oder Verbindungen, bei welchen ein strahlungsbehafteter Übergang von einem angeregten Singulettzustand in den Grundzustand erfolgt. Der Begriff phosphoreszierender Emitter bezeichnet vorzugsweise lumineszierende Materialien oder Verbindungen, die Übergangsmetalle umfassen.

Emitter werden häufig auch als Dotanden bezeichnet, falls die Dotanden die zuvor dargelegten Eigenschaften in einem System hervorufen. Unter einem Dotanden wird in einem System enthaltend ein Matrixmaterial und einen Dotanden diejenige Komponente verstanden, deren Anteil in der Mischung der kleinere ist. Entsprechend wird unter einem Matrixmaterial in einem System enthaltend ein Matrixmaterial und einen Dotanden diejenige Komponente verstanden, deren Anteil in der Mischung der größere ist. Unter dem Begriff phosphoreszierende Emitter können demgemäß beispielsweise auch phosphoreszierende Dotanden verstanden werden.

Verbindungen, welche Licht emittieren können, umfassen unter anderem fluoreszierende Emitter und phosphoreszierende Emitter. Hierzu gehören unter anderem Verbindungen mit Stilben-, Stilbenamin-, Styrylamin-, Coumarin-,

Rubren-, Rhodamin-, Thiazol-, Thiadiazol-, Cyanin-, Thiophen-, Paraphenylen-, Perylen-, Phthalocyanin-, Porphyrin-, Keton-, Chinolin-, Imin-, Anthracen- und/oder Pyren-Strukturen. Besonders bevorzugt sind Verbindungen, die auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o.g. Bedingung erfüllen. Besonders bevorzugt sind hier entsprechende Verbindungen, welche Elemente der Gruppe 8 bis 10 (Ru, Os, Rh, Ir, Pd, Pt) enthalten. Als funktionelle Verbindungen kommen hier z.B. verschiedene Komplexe in Frage, wie sie z.B. in der WO 02/068435 A1, der WO 02/081488 A1, der EP 1239526 A2 und der WO 2004/026886 A2 beschrieben werden.

Nachfolgend werden beispielhaft bevorzugte Verbindungen dargelegt, die als fluoreszierende Emitter dienen können. Bevorzugte fluoreszierende Emitter sind ausgewählt aus der Klasse der Monostyrylamine, der Distyrylamine, der Tristyrylamine, der Tetrastyrylamine, der Styrylphosphine, der Styrylether und der Arylamine.

Unter einem Monostyrylamin wird eine Verbindung verstanden, die eine substituierte oder unsubstituierte Styrylgruppe und mindestens ein, bevorzugt aromatisches, Amin enthält. Unter einem Distyrylamin wird eine Verbindung verstanden, die zwei substituierte oder unsubstituierte Styrylgruppen und mindestens ein, bevorzugt aromatisches, Amin enthält. Unter einem Tristyrylamin wird eine Verbindung verstanden, die drei substituierte oder unsubstituierte Styrylgruppen und mindestens ein, bevorzugt aromatisches, Amin enthält. Unter einem Tetrastyrylamin wird eine Verbindung verstanden, die vier substituierte oder unsubstituierte Styrylgruppen und mindestens ein, bevorzugt aromatisches, Amin enthält. Die Styrylgruppen sind besonders bevorzugt Stilbene, die auch noch weiter substituiert sein können. Entsprechende Phosphine und Ether sind in Analogie zu den Aminen definiert. Unter einem Arylamin bzw. einem aromatischen Amin im Sinne der vorliegenden Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, vorzugsweise mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 2,6- oder 9,10-Position. Aromatische Pyrenamine, Pyrendiamine, Chrysenamine und Chrysendiamine sind analog dazu definiert, wobei die Diarylaminogruppen am Pyren vorzugsweise in 1-Position bzw. in 1,6-Position gebunden sind.

Weitere bevorzugte fluoreszierende Emitter sind ausgewählt aus Indenofluorenaminen bzw. -diaminen, die unter anderem in der WO 2006/122630 dargelegt sind; Benzoindenofluorenaminen bzw. -diaminen, die unter anderem in der WO 2008/006449 dargelegt sind; und Dibenzoindenofluorenaminen bzw. -diaminen, die unter anderem in der WO 2007/140847 offenbart sind.

Beispiele für Verbindungen, die als fluoreszierende Emitter eingesetzt werden können, aus der Klasse der Styrylamine sind substituierte oder unsubstituierte Tristilbenamine oder die Dotanden, die in der WO 2006/000388, der WO 2006/058737, der WO 2006/000389, der WO 2007/065549 und der WO 2007/115610 beschrieben sind. Distyrylbenzolund Distyrylbiphenyl-Derivate sind beschrieben in der US 5121029. Weitere Styrylamine sind in der US 2007/0122656 A1 zu finden.

Besonders bevorzugte Styrylamin-Verbindungen sind die in der US 7250532 B2 beschriebenen Verbindungen der Formel EM-1 und die in der DE 10 2005 058557 A1 offenbarten Verbindungen der Formel EM-2:

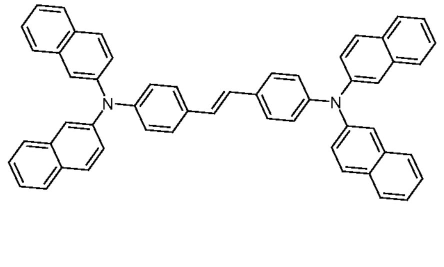

Formel EM-1

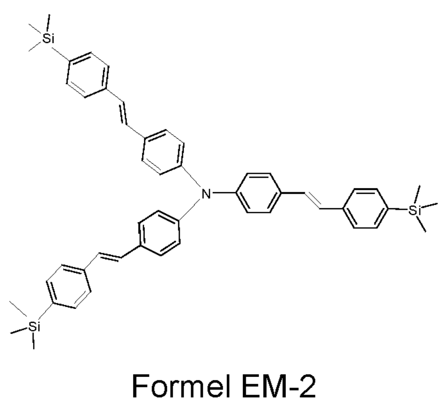

Formel EM-2

Besonders bevorzugte Triarylamin-Verbindungen sind die in der CN 1583691 A, der JP 08/053397 A und der

US 6251531 B1, der EP 1957606 A1, der US 2008/0113101 A1, der US 2006/210830 A, der WO 2008/006449 und der DE 102008035413 offenbarten Verbindungen der Formeln EM-3 bis EM-15 und deren Derivate:

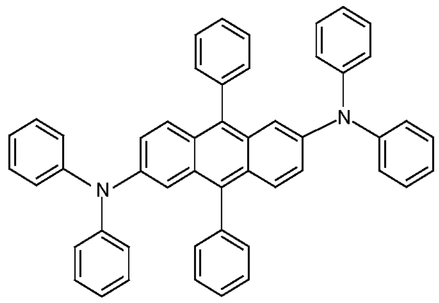

Formel EM-3

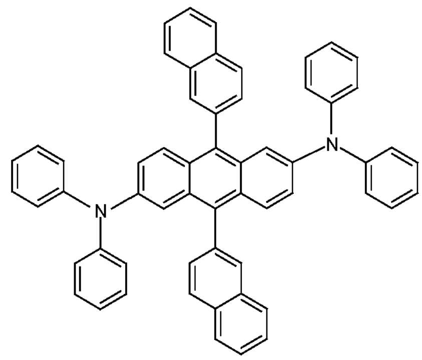

Formel EM-4

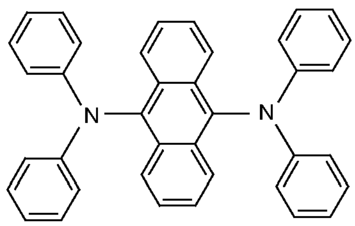

Formel EM-5

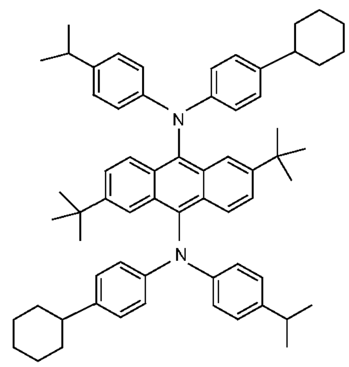

Formel EM-6

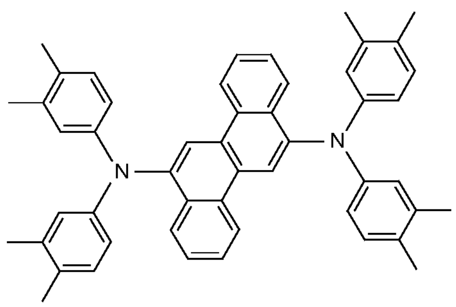

Formel EM-7

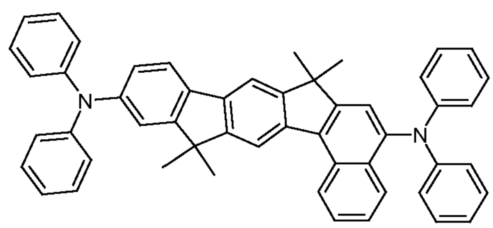

Formel EM-8

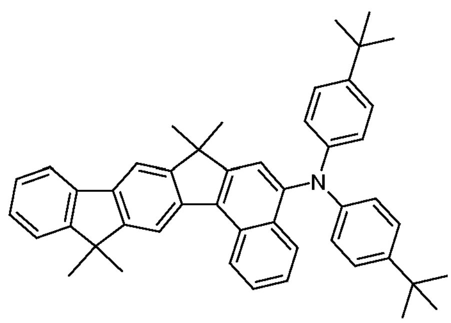

Formel EM-9

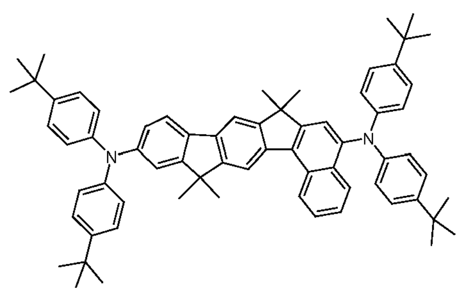

Formel EM-10

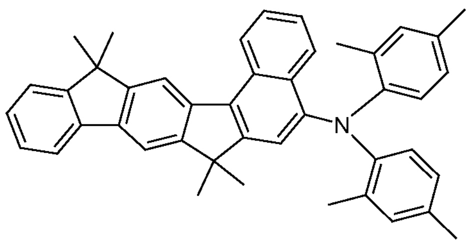

Formel EM-11

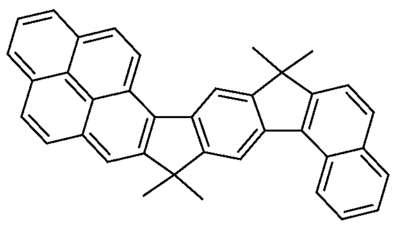

Formel EM-12

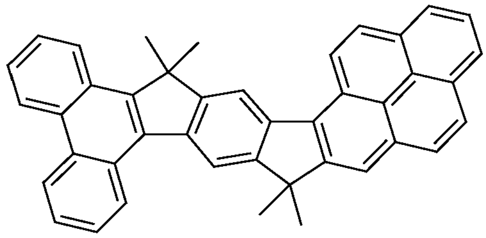

Formel EM-13

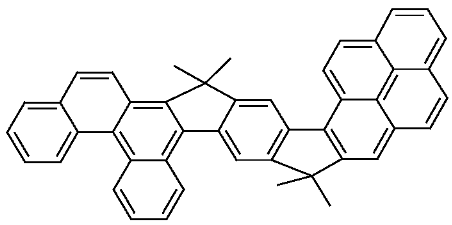

Formel EM-14

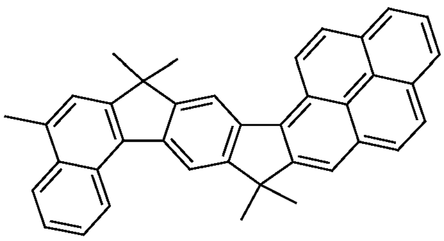

Formel EM-15

Weitere bevorzugte Verbindungen, die als fluoreszierende Emitter eingesetzt werden können, sind ausgewählt aus Derivaten von Naphthalin, Anthracen, Tetracen, Benzanthracen, Benzphenanthren (DE 10 2009 005746), Fluoren, Fluoranthen, Periflanthen, Indenoperylen, Phenanthren, Perylen (US 2007/0252517 A1), Pyren, Chrysen, Decacyclen, Coronen, Tetraphenylcyclopentadien, Pentaphenylcyclopentadien, Fluoren, Spirofluoren, Rubren, Cumarin (US 4769292, US 6020078, US 2007/0252517 A1), Pyran, Oxazol, Benzoxazol, Benzothiazol, Benzimidazol, Pyrazin, Zimtsäureestern, Diketopyrrolopyrrol, Acridon und Chinacridon (US 2007/0252517 A1).

Von den Anthracenverbindungen sind besonders bevorzugt in 9,10-Position substituierte Anthracene wie z.B. 9,10-Diphenylanthracen und 9,10-Bis(phenylethynyl)anthracen. Auch 1,4-Bis(9'-ethynylanthracenyl)-benzol ist ein bevorzugter Dotand.

Ebenfalls bevorzugt sind Derivate von Rubren, Cumarin, Rhodamin, Chinacridon wie z.B. DMQA (= N,N'-dimethylchinacridon), Dicyanomethylenpyran wie z.B. DCM (= 4-(dicyanoethylen)-6-(4-dimethylaminostyryl-2-methyl)-4H-pyran), Thiopyran, Polymethin, Pyrylium- und Thiapyryliumsalzen, Periflanthen und Indenoperylen.

Blaue Fluoreszenzemitter sind vorzugsweise Polyaromaten wie z.B. 9,10-Di(2-naphthylanthracen) und andere Anthracen-Derivate, Derivate von Tetracen, Xanthen, Perylen wie z.B. 2,5,8,11-Tetra-*t*-butyl-perylen, Phenylen, z.B. 4,4'-(Bis(9-ethyl-3-carbazovinylen)-1,1'-biphenyl, Fluoren, Fluoranthen, Arylpyrene (US 2006/0222886 A1), Arylenvinylene (US 5121029, US 5130603), Bis(azinyl)imin-Bor-Verbindungen (US 2007/0092753 A1), Bis(azinyl)methenverbindungen und Carbostyryl-Verbindungen.

Weitere bevorzugte blaue Fluoreszenzemitter sind in C.H.Chen et al.: "Recent developments in organic electroluminescent materials" Macromol. Symp. 125, (1997) 1-48 und "Recent progress of molecular organic electroluminescent materials and devices" Mat. Sci. and Eng. R, 39 (2002), 143-222 beschrieben.

Weitere bevorzugte blau fluoreszierende Emitter sind die in der DE 102008035413 offenbarten Kohlenwasserstoffe.

Nachfolgend werden beispielhaft bevorzugte Verbindungen dargelegt, die als phosphoreszierende Emitter dienen können.

Beispiele für phosphoreszierende Emitter können der WO 00/70655, der WO 01/41512, der WO 02/02714,

der WO 02/15645, der EP 1191613, der EP 1191612, der EP 1191614 und der WO 2005/033244 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden. Phosphoreszierende Metallkomplexe enthalten vorzugsweise Ir, Ru, Pd, Pt, Os oder Re.

Bevorzugte Liganden sind 2-Phenylpyridin-Derivate, 7,8-Benzochinolin-Derivate, 2-(2-Thienyl)pyridin-Derivate, 2-(1-Naphthyl)pyridin-Derivate, 1-Phenylisochinolin-Derivate, 3-Phenylisochinolin-Derivate oder 2-Phenylchinolin-Derivate. Alle diese Verbindungen können substituiert sein, z.B. für Blau mit Fluor-, Cyano- und/oder Trifluormethylsubstituenten. Auxiliäre Liganden sind vorzugsweise Acetylacetonat oder Picolinsäure.

Insbesondere sind Komplexe von Pt oder Pd mit tetradentaten Liganden gemäß Formel EM-16 als Emitter geeignet.

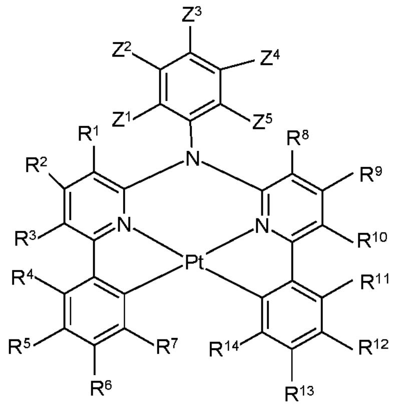

Formel EM-16

Die Verbindungen gemäß der Formel EM-16 sind detaillierter in der US 2007/0087219 A1 dargelegt, wobei zur Erläuterung der Substituenten und Indices in der obigen Formel zu Offenbarungszwecken auf diese Druckschrift verwiesen wird. Weiterhin sind Pt-Porphyrinkomplexe mit vergrößertem Ringsystem (US 2009/0061681 A1) und Ir-Komplexe geeignet, z.B. 2,3,7,8,12,13,17,18-Octaethyl-21H, 23H-porphyrin-Pt(II), Tetraphenyl-Pt(II)-tetrabenzoporphyrin (US 2009/0061681 A1), *cis*-Bis(2-phenylpyridinato-N,$C^{2'}$)Pt(II), *cis*-Bis(2-(2'-thienyl)pyridinato-N,$C^{3'}$)Pt(II), *cis*-Bis-(2-(2'-thienyl)chinolinato-N,$C^{5'}$)Pt(II), (2-(4,6-Difluorophenyl)pyridinato-N,$C^{2'}$)Pt(II)(acetylacetonat), oder Tris(2-phenylpyridinato-N,$C^{2'}$)Ir(III) (= $Ir(ppy)_3$, grün), Bis(2-phenyl-pyridinato-N,$C^2$)Ir(III)(acetylacetonat) (= $Ir(ppy)_2$acetylacetonat, grün, US 2001/0053462 A1, Baldo, Thompson et al. Nature 403, (2000), 750-753), Bis(1-phenylisochinolinato-N,$C^{2'}$)(2-phenylpyridinato-N,$C^{2'}$)Iridium(III), Bis(2-phenylpyridinato-N,$C^{2'}$)(1-phenylisochinolinato-N,$C^{2'}$)Iridium(III), Bis(2-(2'-benzothienyl)pyridinato-N,$C^{3'}$)Iridium(III)(acetylacetonat), Bis(2-(4',6'-difluorophenyl)pyridinato-N,$C^{2'}$)Iridium(III)(piccolinat) (Flrpic, blau), Bis(2-(4',6'-difluorophenyl)-pyridinato-N,$C^{2'}$)Ir(III)(tetrakis(1-pyrazolyl)borat), Tris(2-(biphenyl-3-yl)-4-tertbutylpyridin)iridium(III), $(ppz)_2$Ir(5phdpym) (US 2009/0061681 A1), $(4500ppz)_2$Ir(5phdpym) (US 2009/0061681 A1), Derivate von 2-Phenylpyridin-Ir-Komplexen, wie z.B. PQIr (= Iridium(III)-bis(2-phenylquinolyl-N,$C^{2'}$)acetylacetonat), Tris(2-phenylisochinolinato-N,C)Ir(III) (rot), Bis(2-(2'-benzo[4,5-a]thienyl)pyridinato-N,$C^3$)Ir(acetyl-acetonat) ( [$Btp_2$Ir(acac)], rot, Adachi et al. Appl. Phys. Lett. 78 (2001), 1622-1624).

Ebenfalls geeignet sind Komplexe von trivalenten Lanthaniden wie z.B. $Tb^{3+}$ und $Eu^{3+}$ (J.Kido et al. Appl. Phys. Lett. 65 (1994), 2124, Kido et al. Chem. Lett. 657, 1990, US 2007/0252517 A1) oder phosphoreszente Komplexe von Pt(II), Ir(I), Rh(I) mit Maleonitrildithiolat (Johnson et al., JACS 105, 1983, 1795), Re(I)-Tricarbonyl-diimin-Komplexe (Wrighton, JACS 96, 1974, 998 u.a.), Os(II)-Komplexe mit Cyanoliganden und Bipyridyl- oder Phenanthrolin-Liganden (Ma et al., Synth. Metals 94, 1998, 245).

Weitere phosphoreszierende Emitter mit tridentaten Liganden werden beschrieben in der US 6824895 und der US 10/729238. Rot emittierende phosphoreszente Komplexe findet man in der US 6835469 und der US 6830828.

Besonders bevorzugte Verbindungen, die als phosphoreszierende Dotanden Verwendung finden, sind unter anderem die in der US 2001/0053462 A1 und Inorg. Chem. 2001, 40(7), 1704-1711, JACS 2001, 123(18), 4304-4312 beschriebenen Verbindungen gemäß der Formel EM-17 sowie Derivate hiervon.

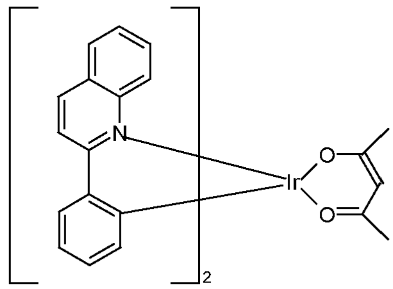

Formel EM-17

Derivate sind beschrieben in der US 7378162 B2, der US 6835469 B2 und der JP 2003/253145 A.

Ferner können die in der US 7238437 B2, der US 2009/008607 A1 und der EP 1348711 beschriebenen Verbindungen gemäß den Formeln EM-18 bis EM-21 sowie deren Derivate als Emitter eingesetzt werden.

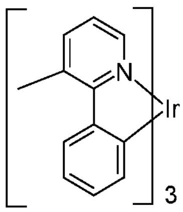

Formel EM-18

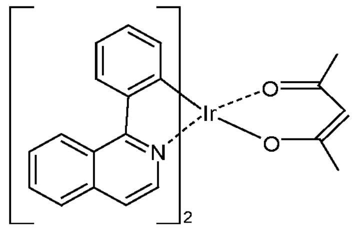

Formel EM-19

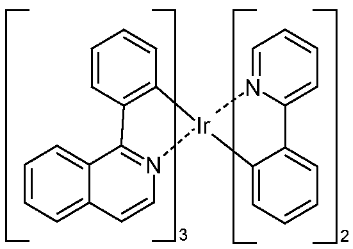

Formel EM-20

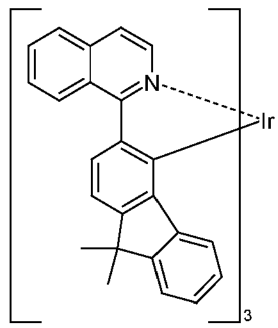

Formel EM-21

Quantum Dots können ebenfalls als Emitter eingesetzt werden, wobei diese Materialien ausführlich in der WO 2011/076314 A1 offenbart werden.

Verbindungen, die als Hostmaterialien, insbesondere zusammen mit emittierenden Verbindungen eingesetzt werden, umfassen Materialien verschiedener Stoffklassen.

Hostmaterialien weisen im Allgemeinen größere Bandlücken zwischen HOMO und LUMO auf, als die eingesetzten Emittermaterialien. Zusätzlich zeigen bevorzugte Hostmaterialien entweder Eigenschaften eines Lochoder Elektronentransportmaterials. Weiterhin können Hostmaterialien sowohl Elektronen- als auch Lochtransporteigenschaften aufweisen.

Hostmaterialien werden zum Teil auch als Matrixmaterial bezeichnet, insbesondere falls das Hostmaterial in Kombination mit einem phosphoreszierenden Emitter in einer OLED eingesetzt wird.

Bevorzugte Host-Materialien oder Co-Host-Materialien, die insbesondere zusammen mit fluoreszierenden Dotanden eingesetzt werden, sind ausgewählt aus den Klassen der Oligoarylene (z.B. 2,2',7,7'-Tetraphenylspirobifluoren gemäß der EP 676461 oder Dinaphthylanthracen), insbesondere der Oligoarylene enthaltend kondensierte aromatische Gruppen wie z.B. Anthracen, Benzanthracen, Benzphenanthren (DE 10 2009 005746, WO 2009/069566), Phenanthren, Tetracen, Coronen, Chrysen, Fluoren, Spirobifluoren, Perylen, Phthaloperylen, Naphthaloperylen, Decacyclen, Rubren, der Oligoarylenvinylene (z.B. DPVBi = 4,4'-Bis(2,2-diphenyl-ethenyl)-1,1'-biphenyl) oder Spiro-DPVBi gemäß der EP

676461), der polypodalen Metallkomplexe (z.B. gemäß der WO 2004/081017), insbesondere Metallkomplexe von 8-Hydroxychinolin, z.B. $AlQ_3$ (= Aluminium(III)tris(8-hydroxychinolin)) oder Bis(2-methyl-8-chinolinolato)-4-(phenylphenolino-lato)aluminium, auch mit Imidazol-Chelat (US 2007/0092753 A1) sowie der Chinolin-Metallkomplexe, Aminochinolin-Metallkomplexe, Benzochinolin-Metallkomplexe, der lochleitenden Verbindungen (z.B. gemäß der WO 2004/058911), der elektronenleitenden Verbindungen, insbesondere Ketone, Phosphinoxide, Sulfoxide, etc. (z.B. gemäß der WO 2005/084081 und der WO 2005/084082), der Atropisomere (z.B. gemäß der WO 2006/048268), der Boronsäurederivate (z.B. gemäß der WO 2006/117052) oder der Benzanthracene (z.B. gemäß der WO 2008/145239).

Besonders bevorzugte Verbindungen, die als Host-Materialien oder Co-Host-Materialien dienen können, sind ausgewählt aus den Klassen der Oligoarylene, enthaltend Anthracen, Benzanthracen und/oder Pyren oder Atropisomere dieser Verbindungen. Unter einem Oligoarylen im Sinne der vorliegenden Erfindung soll eine Verbindung verstanden werden, in der mindestens drei Aryl- bzw. Arylengruppen aneinander gebunden sind.

Bevorzugte Hostmaterialien sind insbesondere ausgewählt aus Verbindungen der Formel (H-1),

$$Ar^4\text{-}(Ar^5)_p\text{-}Ar^6 \qquad \text{(H-1)}$$

wobei $Ar^4$, $Ar^5$, $Ar^6$ bei jedem Auftreten gleich oder verschieden eine Aryloder Heteroarylgruppe mit 5 bis 30 aromatischen Ringatomen ist, die gegebenenfalls substituiert sein kann, und p eine ganze Zahl im Bereich von 1 bis 5 darstellt; dabei gilt, dass die Summe der $\pi$-Elektronen in $Ar^4$, $Ar^5$ und $Ar^6$ mindestens 30 beträgt, wenn p = 1 ist, und mindestens 36 beträgt, wenn p = 2 ist, und mindestens 42 beträgt, wenn p = 3 ist.

Besonders bevorzugt steht in den Verbindungen der Formel (H-1) die Gruppe $Ar^5$ für Anthracen und die Gruppen $Ar^4$ und $Ar^6$ sind in 9- und 10-Position gebunden, wobei diese Gruppen gegebenenfalls substituiert sein können. Ganz besonders bevorzugt ist mindestens eine der Gruppen $Ar^4$ und/oder $Ar^6$ eine kondensierte Arylgruppe, ausgewählt aus 1- oder 2-Naphthyl, 2-, 3- oder 9-Phenanthrenyl oder 2-, 3-, 4-, 5-, 6- oder 7-Benzanthracenyl. Anthracen-basierte Verbindungen werden beschrieben in der US 2007/0092753 A1 und der US 2007/0252517 A1, z.B. 2-(4-Methylphenyl)-9,10-di-(2-naphthyl)anthracen, 9-(2-Naphthyl)-10-(1,1'-biphenyl)anthracen und 9,10-Bis[4-(2,2-diphenylethenyl)phenyl]anthracen, 9,10-Diphenylanthracen, 9,10-Bis(phenylethynyl)anthracen und 1,4-Bis(9'-ethynylanthracenyl)benzol. Bevorzugt sind auch Verbindungen mit zwei Anthraceneinheiten (US 2008/0193796 A1), z.B. 10,10'-Bis[1,1',4', 1"]terphenyl-2-yl-9,9'-bisanthracenyl.

Weitere bevorzugte Verbindungen sind Derivate von Arylamin, Styrylamin, Fluorescein, Diphenylbutadien, Tetraphenylbutadien, Cyclopentadien, Tetraphenylcyclopentadien, Pentaphenylcyclopentadien, Cumarin, Oxadiazol, Bisbenzoxazolin, Oxazol, Pyridin, Pyrazin, Imin, Benzothiazol, Benzoxazol, Benzimidazol (US 2007/0092753 A1), z.B. 2,2',2"-(1,3,5-Phenylen)tris[1-phenyl-1H-benzimidazol], Aldazin, Stilben, Styrylarylenderivate, z.B. 9,10-Bis[4-(2,2-diphenylethenyl)phenyl]anthracen und Distyrylarylen-Derivate (US 5121029), Diphenylethylen, Vinylanthracen, Diaminocarbazol, Pyran, Thiopyran, Diketopyrrolopyrrol, Polymethin, Zimtsäureestern und Fluoreszenzfarbstoffen.

Besonders bevorzugt sind Derivate von Arylamin und Styrylamin, z.B. TNB (= 4,4'-Bis[N-(1-naphthyl)-N-(2-naphthyl)amino]biphenyl). Metall-Oxinoid-Komplexe wie LiQ oder $AlQ_3$ können als Co-Hosts verwendet werden.

Bevorzugte Verbindungen mit Oligoarylen als Matrix werden in der US 2003/0027016 A1, der US 7326371 B2, der US 2006/043858 A, der WO 2007/114358, der WO 2008/145239, der JP 3148176 B2, der EP 1009044, der US 2004/018383, der WO 2005/061656 A1, der EP 0681019B1, der WO 2004/013073A1, der US 5077142, der WO 2007/065678 und der DE 102009005746 offenbart, wobei besonders bevorzugte Verbindungen durch die Formeln H-2 bis H-8 beschrieben sind.

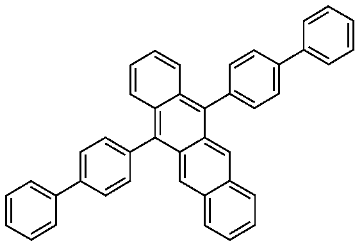

Formel H-2

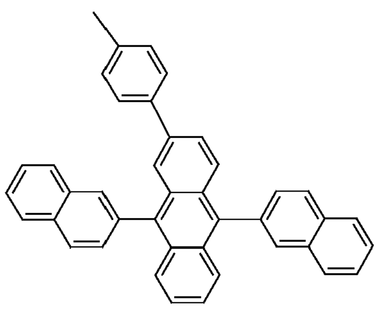

Formel H-3

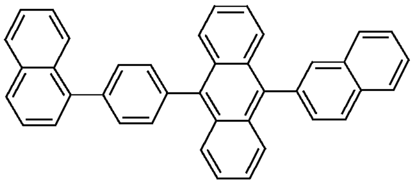

Formel H-4

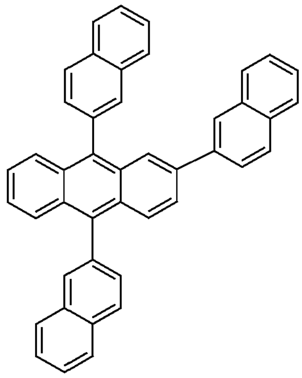

Formel H-5

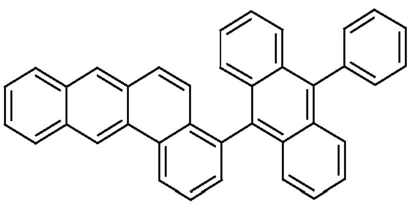

Formel H-6

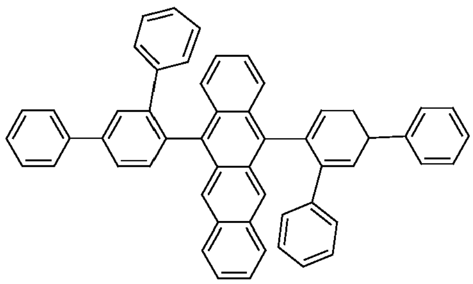

Formel H-7

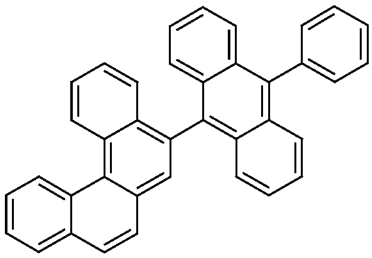

Formel H-8

Weiterhin umfassen Verbindungen, die als Host oder Matrix eingesetzt werden können, Materialien, die zusammen mit phosphoreszierenden Emittern eingesetzt werden. Zu diesen Verbindungen, die auch als Strukturelemente in Polymeren eingesetzt werden können, gehören CBP (N,N-Biscarbazolylbiphenyl), Carbazolderivate (z.B. gemäß der WO 2005/039246, der US 2005/0069729, der JP 2004/288381, der EP 1205527 oder der WO 2008/086851), Azacarbazole (z.B. gemäß der EP 1617710, der EP 1617711, der EP 1731584 oder der JP 2005/347160), Ketone (z.B. gemäß der WO 2004/093207 oder gemäß der DE 102008033943), Phosphinoxide, Sulfoxide und Sulfone (z.B. gemäß der WO 2005/003253), Oligophenylene, aromatische Amine (z.B. gemäß der US 2005/0069729), bipolare Matrixmaterialien (z.B. gemäß der WO 2007/137725), Silane (z.B. gemäß der WO 2005/111172), 9,9-Diarylfluorenderivate (z.B. gemäß der DE 102008017591), Azaborole oder Boronester (z.B. gemäß der WO 2006/117052), Triazin-Derivate (z.B. gemäß der DE 102008036982), Indolocarbazolderivate (z.B. gemäß der WO 2007/063754 oder der WO 2008/056746), Indenocarbazolderivate (z.B. gemäß der DE 102009023155 und der DE 102009031021), Diazaphosphol-derivate (z.B. gemäß der DE 102009022858), Triazol-Derivate, Oxazole und Oxazol-Derivate, Imidazol-Derivate, Polyarylalkan-Derivate, Pyrazolin-Derivate, Pyrazolon-Derivate, Distyrylpyrazin-Derivate, Thiopyrandioxid-Derivate, Phenylendiamin-Derivate, tertiäre aromatische Amine, Styrylamine, Amino-substituierte Chalcon-Derivate, Indole, Hydrazon-Derivate, Stilben-Derivate, Silazan-Derivate, aromatische Dimethyliden-Verbindungen, Carbodiimid-Derivate, Metallkomplexe von 8-Hydroxy-chinolin-Derivaten wie z.B. $AlQ_3$, die 8-Hydroxychinolin-Komplexe können auch Triarylaminophenol-Liganden enthalten (US 2007/0134514 A1), Metallkomplex-Polysilan-Verbindungen sowie Thiophen-, Benzothiophen- und Dibenzothiophen-Derivate.

Beispiele für bevorzugte Carbazol-Derivate sind mCP (= 1,3-N,N-dicarbazol-benzol (= 9,9'-(1,3-Phenylen)bis-9H-carbazol)) (Formel H-9), CDBP (= 9,9'-(2,2'-Dimethyl[1,1'-biphenyl]-4,4'-diyl)bis-9H-carbazol), 1,3-Bis(N,N'-dicarbazol)benzol (= 1,3-Bis(carbazol-9-yl)benzol), PVK (Polyvinylcarbazol), 3,5-Di(9H-carbazol-9-yl)biphenyl sowie CMTTP (Formel H10). Besonders bevorzugte Verbindungen werden in der US 2007/0128467 A1 und der US 2005/0249976 A1 offenbart (Formeln H-11 bis H-13).

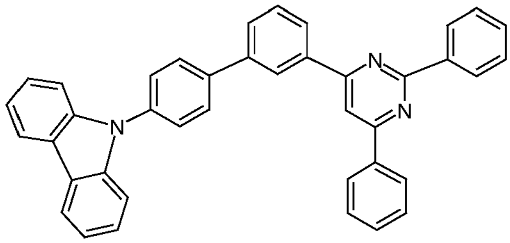

Formel H-9

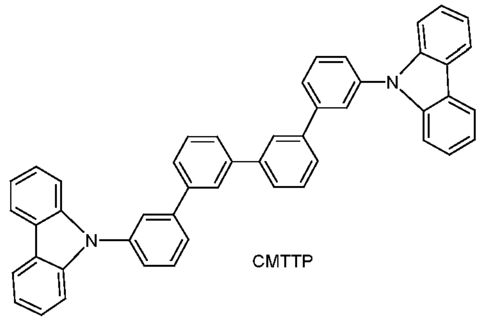

CMTTP

Formel H-10

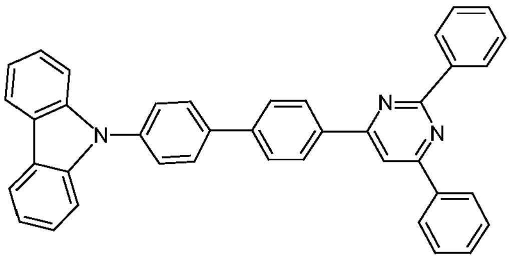

Formel H-11

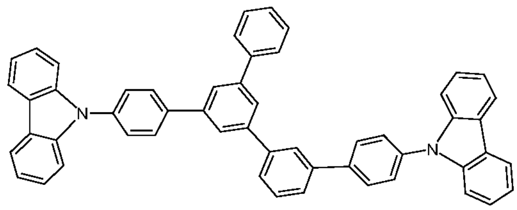

Formel H-12

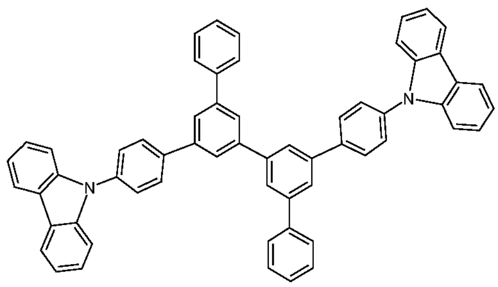

Formel H-13

Bevorzugte Si-Tetraaryle werden z.B. in der US 2004/0209115, der US 2004/0209116, der US 2007/0087219 A1 und in H. Gilman, E.A. Zuech, Chemistry & Industry (London, United Kingdom), 1960, 120 offenbart.

Besonders bevorzugte Si-Tetraaryle werden durch die Formeln H-14 bis H-21 beschrieben.

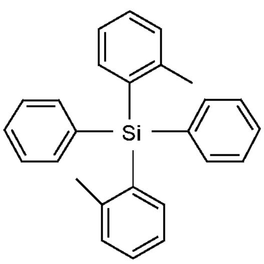

UGH1

Formel H-14

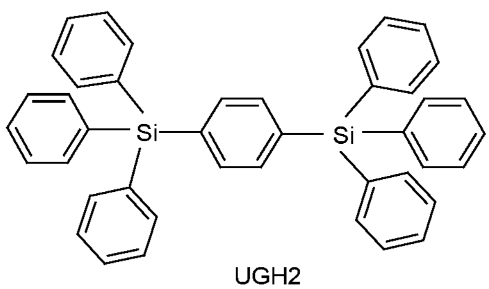

UGH2

Formel H-15

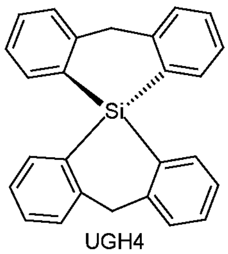

UGH4

Formel H-16

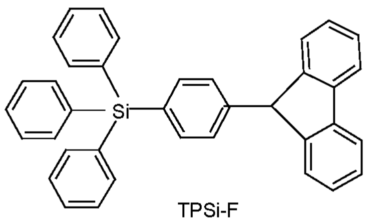

TPSi-F

Triphenyl-[4-(9-phenyl-9H-fluoren-9-yl)phenyl]silane

Formel H-17

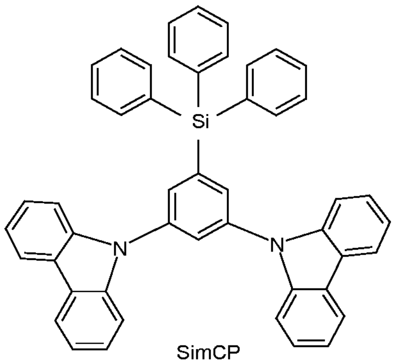

SimCP

Formel H-18

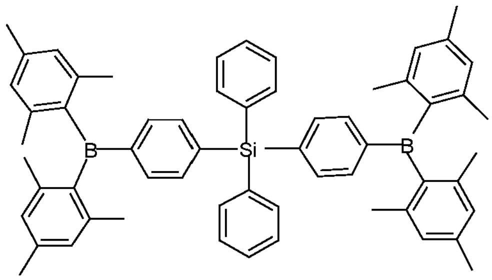

Formel H-19

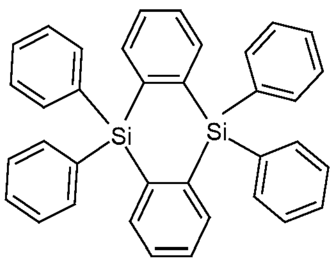

Formel H-20

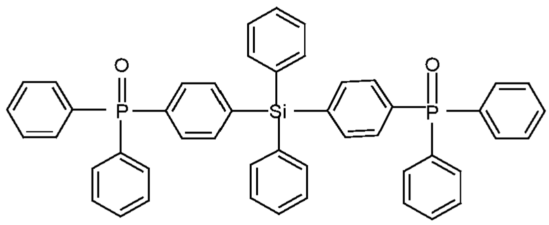

Formel H-21

Besonders bevorzugte Verbindungen zur Herstellung einer Matrix für phosphoreszierende Dotanden werden unter anderem in der DE 102009022858, der DE 102009023155, der EP 652273 B1, der WO 2007/063754 und der WO 2008/056746 offenbart, wobei besonders bevorzugte Verbindungen durch die Formeln H-22 bis H-25 beschrieben werden.

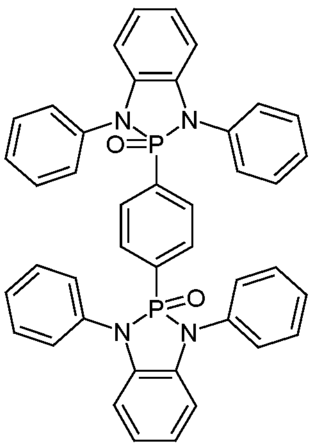

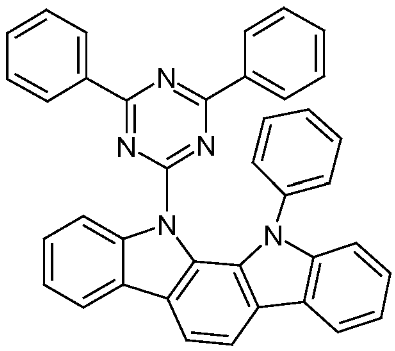

Formel H-22

Formel H-23

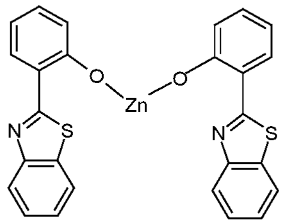

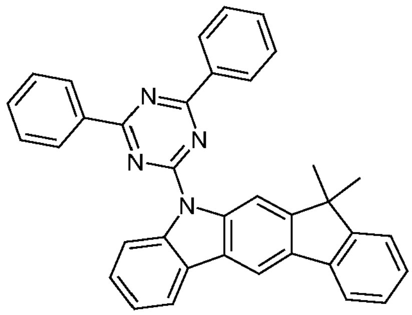

Formel H-24

Formel H-25

Im Hinblick auf die erfindungsgemäß einsetzbaren organischen Halbleiter, die als Hostmaterial dienen können, sind insbesondere Stoffe bevorzugt, die mindestens ein Stickstoffatom aufweisen. Hierzu gehören vorzugsweise aromatische Amine, Triazin- und Carbazol-Derivate. So zeigen insbesondere Carbazol-Derivate eine überraschend hohe Effizienz. Triazin-Derivate führen zu unerwartet hohen Lebensdauern der elektronischen Vorrichtungen.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z.B. in der WO 2010/108579 beschrieben.

Weiterhin können Verbindungen eingesetzt werden, welche den Übergang vom Singulett- zum Triplettzustand verbessern und welche, unterstützend zu Verbindungen mit Emittereigenschaften eingesetzt, die Phosphoreszenzeigenschaften dieser Verbindungen verbessern. Hierfür kommen insbesondere Carbazol- und überbrückte Carbazoldimereinheiten in Frage, wie sie z.B. in der WO 2004/070772 A2 und der WO 2004/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 beschrieben werden.

Unter n-Dotanden werden hierin Reduktionsmittel, d.h. Elektronendonatoren verstanden. Bevorzugte Beispiele für n-Dotanden sind W(hpp)4 und weitere elektronenreiche Metallkomplexe gemäß der WO 2005/086251 A2, P=N-Verbindungen (z.B. WO 2012/175535 A1, WO 2012/175219 A1), Naphthylencarbodiimide (z.B. WO 2012/168358 A1), Fluorene (z.B. WO 2012/031735 A1), Radikale und Diradikale (z.B. EP 1837926 A1, WO 2007/107306 A1), Pyridine (z.B. EP 2452946 A1, EP 2463927 A1), N-heterocyclische Verbindungen (z.B. WO 2009/000237 A1) und Acridine sowie Phenazine (z.B. US 2007/145355 A1).

Weiterhin können die Formulierungen als funktionelles Material ein Wide-Band-Gap-Material enthalten. Unter Wide-Band-Gap-Material wird ein Material im Sinne der Offenbarung der US 7,294,849 verstanden. Diese Systeme zeigen besondere vorteilhafte Leistungsdaten in elektrolumineszierenden Vorrichtungen.

Vorzugsweise kann die als Wide-Band-Gap-Material eingesetzte Verbindung eine Bandlücke (band gap) von 2.5 eV oder mehr, bevorzugt 3.0 eV oder mehr, besonders bevorzugt von 3.5 eV oder mehr aufweisen. Die Bandlücke kann unter anderem durch die Energieniveaus des highest occupied molecular orbital (HOMO) und des lowest unoccupied molecular orbital (LUMO) berechnet werden.

Weiterhin können die Formulierungen als organischen Halbleiter ein Lochblockiermaterial (hole blocking material; HBM) umfassen. Ein Lochblockiermaterial bezeichnet ein Material welches in einem Mehrschichtverbund die Durchleitung von Löchern (positive Ladungen) verhindert oder minimiert, insbesondere falls dieses Material in Form einer Schicht benachbart zu einer Emissionsschicht oder eine lochleitenden Schicht angeordnet ist. Im Allgemeinen hat ein Lochblockiermaterial ein niedrigeres HOMO Niveau als das Lochtransportmaterial in der benachbarten Schicht. Lochblockierschichten werden häufig zwischen der lichtemittierenden Schicht und der Elektronentransportschicht in OLEDs angeordnet.

Grundsätzlich kann jedes bekannte Lochblockiermaterial eingesetzt werden. Zusätzlich zu weiteren Lochblockiermaterialien, die an anderen Stellen in der vorliegenden Anmeldung dargelegt werden, sind zweckmäßige Lochblockiermaterialien Metallkomplexe (US 2003/0068528), wie beispielsweise Bis(2-methyl-8-quinolinolato)(4-phenylphenolato)-aluminium(III) (BAIQ). Fac-tris(1-phenylpyrazolato-N,C2)iridium(III) (Ir(ppz)3) wird ebenfalls für diese Zwecke eingesetzt (US 2003/0175553 A1). Phenanthrolin-Derivate, wie beispielsweise BCP, oder Phthalimide, wie beispielsweise TMPP können ebenfalls eingesetzt werden.

Weiterhin werden zweckmäßige Lochblockiermaterialien in der WO 00/70655 A2, der WO 01/41512 und der WO 01/93642 A1 beschrieben.

Weiterhin können die Formulierungen als organischen Halbleiter ein Elektronenblockiermaterial (electron blocking material; EBM) umfassen. Ein Elektronenblockiermaterial bezeichnet ein Material welches in einem Mehrschichtverbund die Durchleitung von Elektronen verhindert oder minimiert, insbesondere falls dieses Material in Form einer Schicht benachbart zu einer Emissionsschicht oder eine elektronenleitenden Schicht angeordnet ist. Im Allgemeinen hat ein Elektronenblockiermaterial ein höheres LUMO Niveau als das Elektronentransportmaterial in der benachbarten Schicht.

Grundsätzlich kann jedes bekannte Elektronenblockiermaterial eingesetzt werden. Zusätzlich zu weiteren Elektronenblockiermaterialien, die an anderen Stellen in der vorliegenden Anmeldung dargelegt werden, sind zweckmäßige Elektronenblockiermaterialien Übergangsmetall-Komplexe wie beispielsweise $Ir(ppz)_3$ (US 2003/0175553).

Vorzugsweise kann das Elektronenblockiermaterial ausgewählt sein aus Aminen, Triarylaminen und deren Derivativen.

Weiterhin weisen die Verbindungen, die in den Formulierungen als organischen Halbleiter eingesetzt werden können, sofern es sich um niedermolekulare Verbindungen handelt, vorzugsweise ein Molekulargewicht von ≤ 3.000 g/mol, besonders bevorzugt von ≤ 2.000 g/mol und insbesondere bevorzugt von ≤ 1.000 g/mol auf.

Von besonderem Interesse sind des Weiteren organische Halbleitermaterialien, die sich durch eine hohe Glasübergangstemperatur auszeichnen. In diesem Zusammenhang sind Verbindungen, die in den Formulierungen als organisches Halbleitermaterial eingesetzt werden können, bevorzugt, die eine Glasübergangstemperatur von ≥ 70°C, bevorzugt von ≥ 100°C, besonders bevorzugt von ≥ 125°C und insbesondere bevorzugt von ≥ 150°C aufweisen, bestimmt nach DIN 51005:2005-08.

Die Formulierungen können als organische Halbleitermaterialien auch Polymere enthalten. Die zuvor als organische Halbleitermaterialien beschriebenen Verbindungen, die vielfach ein relativ niedriges Molekulargewicht aufweisen, können auch mit einem Polymer gemischt werden. Ebenso ist es möglich, diese Verbindungen kovalent in ein Polymer einzubauen. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. Es ist weiterhin möglich, die Polymere über derartige Gruppen zu vernetzen. Die erfindungsgemäß einsetzbaren Verbindungen und Polymere können als vernetzte oder unvernetzte Schicht eingesetzt werden.

Polymere, die als organische Halbleitermaterialien eingesetzt werden können, umfassen vielfach Einheiten oder Strukturelemente, die im Rahmen der zuvor dargelegten Verbindngen beschrieben wurden u.a. solche, wie sie in der WO 02/077060 A1, in der WO 2005/014689 A2 und in der WO 2011/076314 A1 offenbart und umfangreich aufgelistet sind. Diese werden via Zitat als Bestandteil der vorliegenden Anmeldung betrachtet.

Die funktionellen Materialen können beispielsweise aus den folgenden Klassen stammen:

Gruppe 1: Strukturelemente, die Lochinjektions- und/oder Lochtransporteigenschaften erzeugen können;

Gruppe 2: Strukturelemente, die Elektroneninjektions- und/oder Elektronentransporteigenschaften erzeugen können;

Gruppe 3: Strukturelemente, welche die in Bezug auf Gruppe 1 und 2 dargelegten Eigenschaften kombinieren;

Gruppe 4: Strukturelemente, welche lichtemittierende Eigenschaften aufweisen, insbesondere phosphoreszierende

Gruppen;

Gruppe 5: Strukturelemente, welche den Übergang vom so genannten Singulett- zum Triplettzustand verbessern;

Gruppe 6: Strukturelemente, welche die Morphologie oder auch die Emissionsfarbe der resultierenden Polymere beeinflussen;

Gruppe 7: Strukturelemente, welche typischerweise als Backbone verwendet werden.

Die Strukturelemente können hierbei auch verschiedene Funktionen aufweisen, so dass eine eindeutige Zuordnung nicht zweckmäßig sein muss. Beispielsweise kann ein Strukturelement der Gruppe 1 ebenfalls als Backbone dienen.

Vorzugsweise kann das als organisches Halbleitermaterial eingesetzte Polymer mit Lochtransport- oder Lochinjektionseigenschaften, umfassend Strukturelemente gemäß Gruppe 1, Einheiten aufweisen, die den Lochtransport- oder Lochinjektionmaterialien entsprechen, die zuvor dargelegt wurden.

Weitere bevorzugte Strukturelemente der Gruppe 1 sind beispielsweise Triarylamin-, Benzidin-, Tetraaryl-para-phenylen-diamin-, Carbazol-, Azulen-, Thiophen-, Pyrrol- und Furanderivate und weitere O, S oder N-haltige Heterocyclen mit hoch liegendem HOMO. Diese Arylamine und Heterocyclen weisen vorzugsweise ein HOMO von mehr als -5,8 eV (gegen Vakuumlevel), besonders bevorzugt von mehr als -5,5 eV auf.

Bevorzugt sind unter anderem Polymere mit Lochtransport- oder Lochinjektionseigenschaften, umfassend zumindest eine der folgenden Wiederholungseinheiten gemäß Formel HTP-1

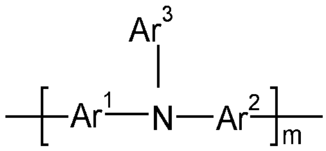

HTP-1

worin die Symbole die folgende Bedeutung aufweisen:

$Ar^1$ ist für unterschiedliche Wiederholungseinheiten jeweils gleich oder verschieden, eine Einfachbindung, oder eine einkernige oder mehrkernige Arylgruppe, die optional substiuiert sein kann;

$Ar^2$ ist für unterschiedliche Wiederholungseinheiten jeweils gleich oder verschieden, eine einkernige oder mehrkernige Arylgruppe, die optional substiuiert sein kann;

$Ar^3$ ist für unterschiedliche Wiederholungseinheiten jeweils gleich oder verschieden, eine einkernige oder mehrkernige Arylgruppe, die optional substiuiert sein kann;

m ist 1, 2 or 3.

Besonders bevorzugt sind Wiederholungseinheiten der Formel HTP-1, die ausgewählt sind aus der Gruppe bestehend aus Einheiten der Formeln HTP-1A bis HTP-1C:

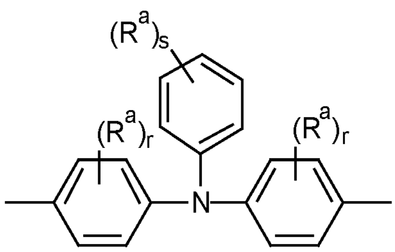

HTP-1A

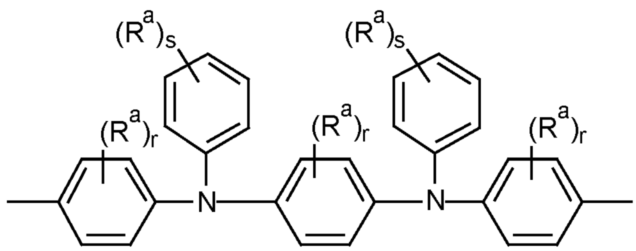

HTP-1B

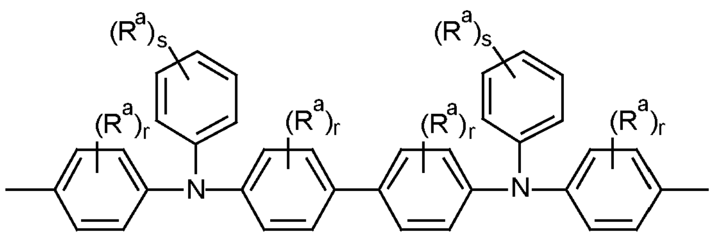

HTP-1C

worin die Symbole die folgende Bedeutung aufweisen:

$R^a$ ist bei jedem Auftreten gleich oder verschieden H, eine substituierte oder unsubstituierte aromatische oder heteroaromatische Gruppe, eine Alkyl-, Cycloalkyl-, Alkoxy-, Aralkyl-, Aryloxy-, Arylthio-, Alkoxycarbonyl-, Silyl-, Carboxygruppe, ein Halogenatom, eine Cyanogruppe, eine NitroGruppe oder eine Hydroxy-Gruppe;

r ist 0, 1, 2, 3 oder 4 und

s ist 0, 1, 2, 3, 4 oder 5.

Bevorzugt sind unter anderem Polymere mit Lochtransport- oder Lochinjektionseigenschaften, umfassend zumindest eine der folgenden Wiederholungseinheit gemäß Formel HTP-2

$$-(T^1)_c-(Ar^7)_d-(T^2)_e-(Ar^8)_f- \qquad \text{HTP-2}$$

worin die Symbole die folgende Bedeutung aufweisen:

$T^1$ und $T^2$ sind unabhängig ausgewählt aus Thiophen, Selenophen, Thieno[2,3b]thiophen, Thieno[3,2b]thiophen, Dithienothiophen, Pyrrol, Anilin , wobei diese Gruppen mit einem oder mehreren Resten $R^b$ substituiert sein können;

$R^b$ ist bei jedem Auftreten unabhängig ausgewählt aus Halogen, -CN, -NC, -NCO, -NCS, -OCN, SCN, $C(=O)NR^0R^{00}$, -C(=O)X, $-C(=O)R^0$, $-NH_2$, $-NR^0R^{00}$, SH, $SR^0$, $-SO_3H$, $-SO_2R^0$, -OH, $-NO_2$, -CFs, -SFs, einer optional substitutierten Silyl-, Carbyl- oder Hydrocarbyl-Gruppe mit 1 bis 40 Kohlenstoffatomen, die optional substituiert sein kann und optional eine oder mehrere Heteroatome umfassen kann;

$R^0$ und $R^{00}$ sind jeweils unabhängig H oder eine optional substitutierte Carbyl- oder Hydrocarbyl-Gruppe mit 1 bis 40 Kohlenstoffatomen, die optional substituiert sein kann und optional eine oder mehrere Heteroatome umfassen kann;

$Ar^7$ und $Ar^8$ stellen unabhängig voneinander eine einkernige oder mehrkernige Aryl- oder Heteroarylgruppe dar, die optional substiuiert sein kann und optional an die 2,3 Position von einer oder beiden benachbarten Thiophen- oder Selenophen-Gruppen gebunden sein kann;

c und e sind unabhängig voneinander 0, 1, 2, 3 oder 4, wobei $1 < c + e \leq 6$,

d und f sind unabhängig voneinander 0, 1, 2, 3 oder 4.

Bevorzugte Beispiele für Polymere mit Lochtransport- oder Lochinjektionseigenschaften sind unter anderem in der WO 2007/131582 A1 und der WO 2008/009343 A1 beschrieben.

Vorzugsweise kann das als organisches Halbleitermaterial eingesetzte Polymer mit Elektroneninjektions- und/oder Elektronentransporteigenschaften, umfassend Strukturelemente gemäß Gruppe 2, Einheiten aufweisen, die den Elektroneninjektions- und/oder Elektronentransportmaterialien entsprechen, die zuvor dargelegt wurden.

Weitere bevorzugte Strukturelemente der Gruppe 2, die Elektroneninjektions- und/oder Elektronentransporteigenschaften umfassen, sind beispielsweise von Pyridin-, Pyrimidin-, Pyridazin-, Pyrazin-, Oxadiazol-, Chinolin-, Chinoxalin- und Phenazin-Gruppen abgeleitet, aber auch Triarylborangruppen oder weitere O, S-oder N-haltige Heterocyclen mit niedrig liegendem LUMO-Niveau. Vorzugsweise weisen diese Strukturelemente der Gruppe 2 ein LUMO von weniger als -2,7 eV (gegen Vakuumlevel), besonders bevorzugt von weniger als -2,8 eV auf.

Vorzugsweise kann das organische Halbleitermaterial ein Polymer sein, welches Strukturelemente gemäß Gruppe 3 umfasst, wobei Strukturelemente, welche die Loch- und die Elektronenmobilität verbessern (d.h. Strukturelemente gemäß den Gruppen 1 und 2) direkt miteinander verbunden sind. Einige dieser Strukturelemente können hierbei als Emitter dienen, wobei die Emissionsfarben beispielsweise ins Grüne, Rote oder Gelbe verschoben werden können. Ihre Verwendung ist daher beispielsweise für die Erzeugung von anderen Emissionsfarben oder einer Breitband-Emission durch Polymere zweckmäßig, die ursprünglich blau emittieren.

Vorzugsweise kann ein Polymer mit lichtemittierenden Eigenschaften, umfassend Strukturelemente gemäß der Gruppe 4, eingesetzt werden, die den Emittermaterialien entsprechen, die zuvor dargelegt wurden. Hierbei sind Polymere mit phosphoreszierenden Gruppen bevorzugt, insbesondere die zuvor dargelegten emittierenden Metall-Komplexe, welche entsprechende Einheiten mit Elementen der Gruppe 8 bis 10 enthalten (Ru, Os, Rh, Ir, Pd, Pt).

Vorzugsweise kann ein Polymer mit Einheiten der Gruppe 5, welche den Übergang vom so genannten Singulett- zum Triplettzustand verbessern, zur Unterstützung von phosphoreszierenden Verbindungen, vorzugsweise die zuvor dargelegten Polymere mit Strukturelementen der Gruppe 4 eingesetzt werden. Hierbei kann eine polymere Triplett-Matrix verwendet werden.

Geeignet für diesen Zweck sind insbesondere Carbazol- und verbundene Carbazoldimereinheiten, wie z.B. in der DE 10304819 A1 und der DE 10328627 A1 beschrieben. Auch für diesen Zweck geeignet sind Keton-, Phosphinoxid-, Sulfoxid-, Sulfon-, Silan-Derivate und ähnliche Verbindungen, wie z.B. in der DE 10349033 A1 beschrieben. Weiterhin können bevorzugte Struktureinheiten von Verbindungen abgeleitet sein, die zuvor im Zusammenhang mit den Matrixmaterialien beschrieben wurden, die zusammen mit phosphoreszierenden Verbindungen eingesetzt werden.

Vorzugsweise ein Polymer eingesetzt werden, das Einheiten der Gruppe 6 umfasst, die die Morphologie und/oder die Emissionsfarbe der Polymere beeinflussen. Dies sind neben den oben genannten Polymeren, solche, die mindestens noch eine weitere aromatische oder eine andere konjugierte Struktur aufweisen, welche nicht zu den oben genannten Gruppen zählen. Diese Gruppen haben demgemäß nur geringe oder keine Auswirkungen auf die Ladungsträger-mobilitäten, die nicht metallorganische Komplexe oder den Singulett-Triplett-Übergang.

Derartige Struktureinheiten können die Morphologie und/oder die Emissionsfarbe der resultierenden Polymere beeinflussen. Je nach Struktureinheit können diese Polymere daher auch als Emitter verwendet werden.

Im Fall von fluoreszierenden OLEDs sind daher aromatische Strukturelemente mit 6 bis 40 C-Atomen oder auch Tolan-, Stilben- oder Bisstyrylarylenderivat-Einheiten, von denen jede durch einen oder mehrere Reste substituiert sein kann. Besonders bevorzugt ist dabei die Verwendung von Gruppen, die von 1,4-Phenylen-, 1,4-Naphthylen-, 1,4oder 9,10-Anthrylen-, 1,6-, 2,7- oder 4,9-Pyrenylen-, 3,9- oder 3,10-Perylenylen-, 4,4'-Biphenylen-, 4,4"-Terphenylylen-, 4,4' bi 1,1'-Naphthylylen-, 4,4'-Tolanylen-, 4,4'-Stilbenylen- oder 4,4"-Bisstyrylarylen-Derivaten abgeleitet sind.

Vorzugsweise umfasst ein Polymer Einheiten der Gruppe 7, die bevorzugt aromatische Strukturen mit 6 bis 40 C-Atomen, die vielfach als Backbone verwendet werden, enthalten.

Hierzu gehören unter anderem 4,5-Dihydropyrenderivate, 4,5,9,10-Tetrahydropyrenderivate, Fluorenderivate, die z.B. in der US 5962631, der WO 2006/052457 A2 und der WO 2006/118345 A1 offenbart werden, 9,9-Spirobifluoren-Derivate, die z.B. in der WO 2003/020790 A1 offenbart werden, 9,10-Phenanthren-Derivate, die z.B. in der WO 2005/104264 A1 offenbart werden, 9,10-Dihydrophenanthren-Derivate, die z.B. in der WO 2005/014689 A2 offenbart werden, 5,7-Dihydrodibenzooxepin-Derivate und cis-und trans-Indenofluoren-Derivate, die z.B. in der WO 2004/041901 A1 und der WO 2004/113412 A2 offenbart werden, und Binaphthylen-Derivate, die z.B. in der WO 2006/063852 A1 offenbart werden, und weitere Einheiten, die z.B. in der WO 2005/056633 A1, der EP 1344788 A1, der WO 2007/043495 A1, der WO 2005/033174 A1, der WO 2003/099901 A1 und der DE 102006003710 offenbart werden.

Besonders bevorzugt sind Struktureinheiten der Gruppe 7, die ausgewählt sind aus Fluoren-Derivaten, die z.B. in der US 5,962,631, der WO 2006/052457 A2 und der WO 2006/118345 A1 offenbart werden; Spirobifluoren-Derivate, die z.B. in der WO 2003/020790 A1 offenbart werden; Benzofluoren-, Dibenzofluoren-, Benzothiophen-, Dibenzofluoren-Gruppen und deren Derivate, die z.B. in der WO 2005/056633 A1, der EP 1344788 A1 und der WO 2007/043495 A1 offenbart werden.

Insbesondere bevorzugte Strukturelemente der Gruppe 7 werden durch die allgemeine Formel PB-1 dargestellt:

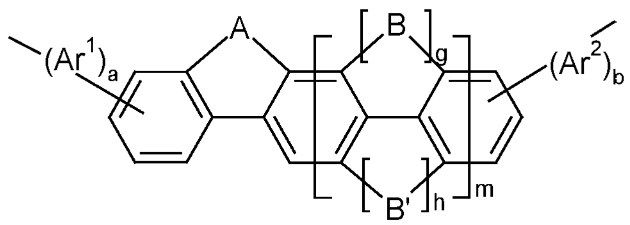

Formel PB-1

worin die Symbole und Indices die folgenden Bedeutungen aufweisen:

A, B und B' sind jeweils, auch für unterschiedliche Wiederholungseinheiten, gleich oder verschieden eine divalente Gruppe, die vorzugsweise ausgewählt ist aus $-CR^cR^d-$, $-NR^c-$, $-PR^c-$, -O-, -S-, -SO-, $-SO_2-$, -CO-, -CS-, -CSe-, $-P(=O)R^c-$, $-P(=S)R^c-$ und $-SiR^cR^d-$;

$R^c$ und $R^d$ sind bei jedem Auftreten unabhängig ausgewählt aus H, Halogen, -CN, -NC, -NCO, -NCS, -OCN, -SCN, $-C(=)NR^0R^{00}$, -C(=O)X, $-C(=O)R^0$, $-NH_2$, $-NR^0R^{00}$, -SH, $-SR^0$, $-SO_3H$, $-SO_2R^0$, -OH, $-NO_2$, $-CF_3$, $-SF_5$, einer optional substitutierten Silyl-, Carbyl- oder Hydrocarbyl-Gruppe mit 1 bis 40 Kohlenstoffatomen, die optional substituiert sein kann und optional eine oder mehrere Heteroatome umfassen kann, wobei die Gruppen $R^c$ und $R^d$ optional eine Spirogruppe mit einem Fluorenrest bilden können, an den sie gebunden sind;

X ist Halogen;

$R^0$ und $R^{00}$ sind jeweils unabhängig H oder eine optional substitutierte Carbyl- oder Hydrocarbyl-Gruppe mit 1 bis 40 Kohlenstoffatomen, die optional substituiert sein kann und optional eine oder mehrere Heteroatome umfassen kann;

g ist jeweils unabhängig 0 oder 1 und h ist jeweils unabhängig 0 oder 1, wobei in einer Untereinheit die Summe von g und h vorzugsweise 1 ist;

m ist eine ganze Zahl $\geq 1$;

$Ar^1$ und $Ar^2$ stellen unabhängig voneinander eine einkernige oder mehrkernige Aryl- oder Heteroarylgruppe dar, die optional substiuiert sein kann und optional an die 7,8-Position oder die 8,9-Position einer Indenofluoren-Gruppen gebunden sein kann;

a und b sind unabhängig voneinander 0 oder 1.

Falls die Gruppen $R^c$ und $R^d$ eine Spirogruppe mit der Fluorengruppe, an die diese Gruppen gebunden sind, bilden, so stellt diese Gruppe vorzugsweise ein Spirobifluoren dar.

Besonders bevorzugt sind Wiederholungseinheiten der Formel PB-1, die ausgewählt sind aus der Gruppe bestehend aus Einheiten der Formeln PB-1A bis PB-1E:

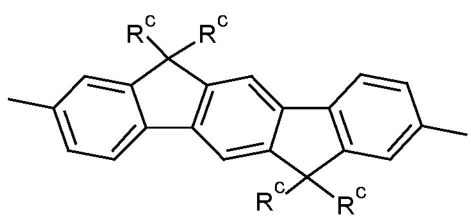

Formel PB-1A

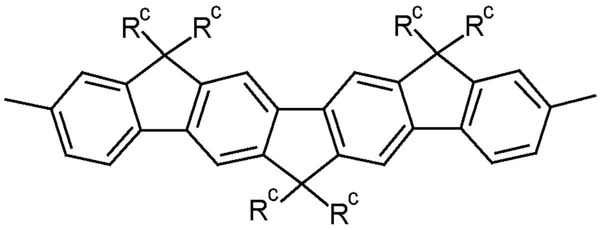

Formel PB-1B

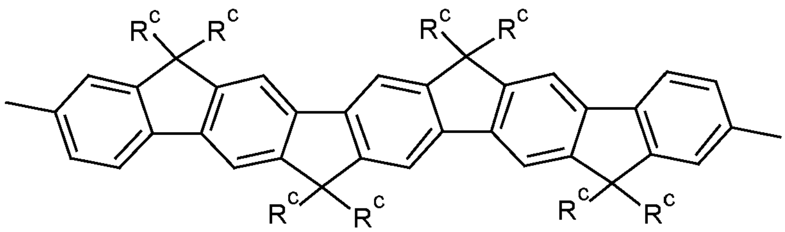

Formel PB-1C

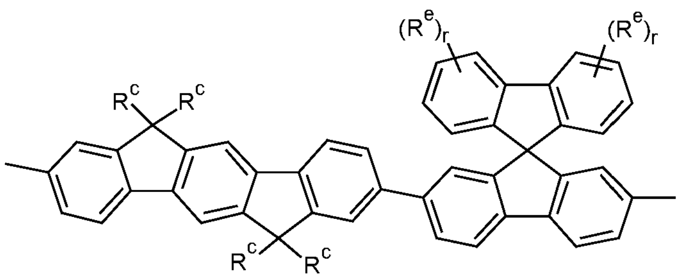

Formel PB-1D

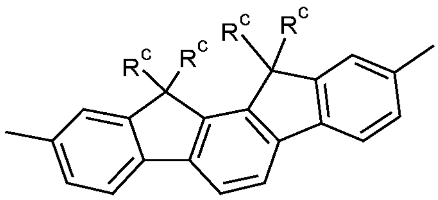

Formel PB-1E

wobei $R^c$ die zuvor für Formel PB-1 dargelegte Bedeutung hat, r 0, 1, 2, 3 oder 4 ist, und $R^e$ die gleiche Bedeutung hat wie der Rest $R^c$.

$R^e$ ist vorzugsweise -F, -Cl, -Br, -I, -CN, $-NO_2$, -NCO, -NCS, -OCN, -SCN, $-C(=O)NR^0R^{00}$, -C(=O)X, $-C(=O)R^0$, $-NR^0R^{00}$, eine optional substituierte Silyl-, Aryl- oder Heteroaryl-Gruppe mit 4 bis 40, vorzugsweise 6 bis 20 C-Atomen, oder eine geradkettige, verzweigte oder cyclische Alkyl-, Alkoxy-, Alkylcarbonyl-, Alkoxycarbonyl-, Alkylcarbonyloxy- oder Alkoxycarbonyloxy-Gruppe mit 1 bis 20, vorzugsweise 1 bis 12 C-Atomen, wobei eine oder mehrere Wasserstoffatome optional durch F oder Cl substituiert sein können, und die Gruppen $R^0$, $R^{00}$ und X die zuvor für Formel PB-1 dargelegte Bedeutung haben.

Besonders bevorzugt sind Wiederholungseinheiten der Formel PB-1, die ausgewählt sind aus der Gruppe bestehend aus Einheiten der Formeln PB-1F bis PB-1I:

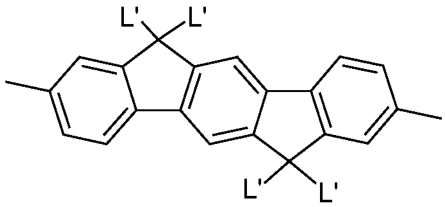

Formel PB-1F

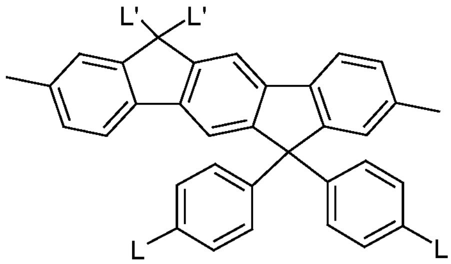

Formel PB-1G

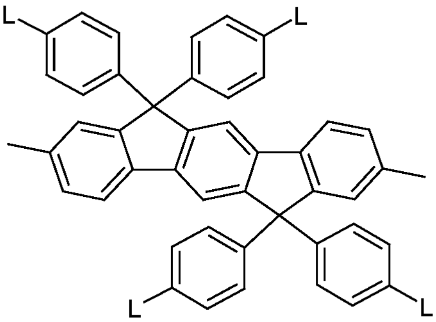

Formel PB-1H

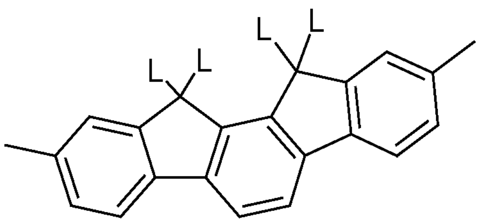

Formel PB-1I

worin die Symbole die folgende Bedeutung aufweisen:

L ist H, Halogen oder eine gegebenenfalls fluorierte, lineare oder verzweigte Alkyl- oder Alkoxy-Gruppe mit 1 bis 12 C-Atomen und steht vorzugsweise für H, F, Methyl, i-Propyl, t-Butyl, n-Pentoxy, oder Trifluormethyl; und

L' ist eine gegebenenfalls fluorierte, lineare oder verzweigte Alkyl- oder Alkoxy-Gruppe mit 1 bis 12 C-Atomen und steht vorzugsweise für n-Octyl oder n-Octyloxy.

Bevorzugt sind zur Durchführung der vorliegenden Erfindung Polymere, welche mehr als eine der zuvor dargelegten Strukturelemente der Gruppen 1 bis 7 aufweisen. Weiterhin kann vorgesehen sein, dass vorzugsweise die Polymere mehr als eine der zuvor dargelegten Strukturelemente aus einer Gruppe aufweisen, also Mischungen von Strukturelementen, die aus einer Gruppe ausgewählt sind, umfassen.

Besonders bevorzugt sind insbesondere Polymere, die neben mindestens einem Strukturelement, welches

lichtemittierende Eigenschaften (Gruppe 4), vorzugsweise mindestens eine phosphoreszierende Gruppe aufweist, zusätzlich mindestens ein weiteres Strukturelement der zuvor dargelegten Gruppen 1 bis 3, 5 oder 6 umfassen, wobei diese vorzugsweise ausgewählt sind aus den Gruppen 1 bis 3.

Der Anteil der verschiedenen Klassen von Gruppen, falls im Polymer vorhanden, kann in weiten Bereichen liegen, wobei diese dem Fachmann bekannt sind. Überraschende Vorteile können dadurch erzielt werden, dass der Anteil einer in einem Polymer vorhandenen Klasse, die jeweils ausgewählt ist aus den zuvor dargelegten Strukturelementen der Gruppen 1 bis 7, vorzugsweise jeweils $\geq$ 5 Mol-%, besonders bevorzugt jeweils $\geq$ 10 Mol-% beträgt.

Die Herstellung von weiß emittierenden Copolymeren wird unter anderem in der DE 10343606 A1 detailliert beschrieben.

Zur Verbesserung der Löslichkeit können die Polymere entsprechende Gruppen aufweisen. Vorzugsweise kann vorgesehen sein, dass die Polymere Substituenten aufweisen, so dass im Mittel pro Wiederholungseinheit zumindest 2 nicht-aromatische Kohlenstoffatome, besonders bevorzugt mindestens 4 und insbesondere bevorzugt mindestens 8 nicht-aromatische Kohlenstoffatome enthalten sind, wobei sich der Mittelwert auf das Zahlenmittel bezieht. Hierbei können einzelne Kohlenstoffatome beispielsweise durch O oder S ersetzt sein. Es ist jedoch möglich, dass ein gewisser Anteil, gegebenenfalls alle Wiederholungseinheiten keine Substituenten aufweisen, die nicht-aromatische Kohlenstoffatomen umfassen. Hierbei sind kurzkettige Substituenten bevorzugt, da langkettige Substituenten nachteilige Auswirkungen auf Schichten haben können, die unter Verwendung der organisch funktionellen Materialien erhalten werden können. Vorzugsweise weisen die Substituenten höchstens 12 Kohlenstoffatome, bevorzugt höchstens 8 Kohlenstoffatome und besonders bevorzugt höchstens 6 Kohlenstoffatome in einer linearen Kette auf.

Ein als organisches Halbleitermaterial erfindungsgemäß eingesetzte Polymer kann ein statistisches, alternierendes oder regioreguläres Copolymer, ein Blockcopolymer oder eine Kombination dieser Copolymerformen sein.

In einer weiteren Ausführungsform kann ein als organisches Halbleitermaterial eingesetzte Polymer ein nichtkonjugiertes Polymer mit Seitenketten sein, wobei diese Ausführungsform insbesondere für phosphoreszierende OLEDs wichtig ist, die auf Polymeren basieren. Im allgemeinen können phosphoreszierende Polymere durch radikalische Copolymerisation von Vinylverbindungen erhalten werden, wobei diese Vinylverbindungen mindestens eine Einheit mit einem phosphoreszierenden Emitter und/oder mindestens eine Ladungstransporteinheit enthalten, wie dies unter anderem in der US 7250226 B2 offenbart wird. Weitere phosphoreszierende Polymere werden unter anderem in der JP 2007/211243 A2, der JP 2007/197574 A2, der US 7250226 B2 und der JP 2007/059939 A beschrieben.

In einer weiteren bevorzugten Ausführungsform umfassen die nicht-konjugierten Polymere Backbone-Einheiten, die durch Spacer-Einheiten miteinander verbunden sind. Beispiele für solche Triplett-Emitter, die auf nicht-konjugierten Polymeren auf Basis von Backbone-Einheiten basieren, werden z.B. in der DE 102009023154 offenbart.

In einer weiteren bevorzugten Ausführungsform kann das nicht-konjugierte Polymer als fluoreszierender Emitter ausgestaltet sein. Bevorzugte fluoreszierende Emitter, die auf nicht-konjugierten Polymeren mit Seitenketten basieren, umfassen Anthracen-, Benzanthracen-Gruppen oder Derivate dieser Gruppen in der Seitenkette, wobei diese Polymere z.B. in der JP 2005/108556, der JP 2005/285661 und der JP 2003/338375 offenbart werden.

Diese Polymere können vielfach als Elektronen- oder Lochtransportmaterialien eingesetzt werden, wobei diese Polymere vorzugsweise als nicht-konjugierte Polymere ausgestaltet sind.

Weiterhin weisen die in den Formulierungen als organisches Halbleitermaterial eingesetzten funktionellen Verbindungen, im Fall von polymeren Verbindungen, vorzugsweise ein Molekulargewicht $M_w$ von $\geq$ 10.000 g/mol, besonders bevorzugt von $\geq$ 20.000 g/mol und insbesondere bevorzugt von $\geq$ 50.000 g/mol auf.

Das Molekulargewicht $M_w$ der Polymere liegt dabei vorzugsweise im Bereich von 10.000 bis 2.000.000 g/mol, besonders bevorzugt im Bereich von 20.000 bis 1.000.000 g/mol und ganz besonders bevorzugt im Bereich von 50.000 bis 300.000 g/mol. Die Bestimmung des Molekulargewichts $M_w$ erfolgt mittels GPC (= Gelpermeationschromatographie) gegen einen internen Polystyrolstandard.

Die zuvor zitierten Druckschriften zur Beschreibung der organischen Halbleitermaterialien werden in die vorliegende Anmeldung zu Offenbarungszwecken durch Referenz hierauf eingefügt.

Die erfindungsgemäß einsetzbaren Formulierungen können sämtliche organisch funktionellen Materialien enthalten, welche zur Herstellung der jeweiligen Funktionsschicht der elektronischen Vorrichtung notwendig sind. Ist z.B. eine Lochtransport-, Lochinjektions-, Elektronentransport-, Elektronen-injektionsschicht genau aus einer funktionellen Verbindung aufgebaut, so umfasst die Formulierung als organisch funktionelles Material genau diese Verbindung. Weist eine Emissionsschicht beispielsweise einen Emitter im Kombination mit einem Matrix- oder Hostmaterial auf, so umfasst die Formulierung als organisch funktionelles Material genau die Mischung von Emitter und Matrix- oder Hostmaterial, wie dies in der vorliegenden Anmeldung an anderer Stelle ausführlicher dargelegt ist.

Der Anteil an organisch funktionellem Material, welches zur Herstellung von Funktionsschichten elektronischer Vorrichtungen einsetzbar ist, in der Formulierung liegt vorzugsweise im Bereich von 0,1 bis 20 Gew.-%, besonders bevorzugt im Bereich von 0,3 bis 10 Gew.-%, und insbesondere bevorzugt im Bereich von 0,5 bis 5 Gew.-%, bezogen auf das Gesamtgewicht der Formulierung.

Neben den genannten Komponenten kann eine erfindungsgemäß einsetzbare Formulierung weitere Additive

und Verarbeitungshilfsmittel umfassen. Hierzu gehören unter anderem oberflächenaktive Stoffe, Tenside, Gleit- und Schmiermittel, Additive, die die Leitfähigkeit erhöhen, Dispergiermittel, Hydrophobisierungsmittel, Haftvermittler, Fließverbesserer, Entschäumer, Entlüfter, Verdünnungsmittel, die reaktiv oder unreaktiv sein können, Füllstoffe, Hilfsstoffe, Verarbeitungshilfsmittel, Farbstoffe, Pigmente, Stabilisatoren, Sensibilisatoren, Nanopartikel und Inhibitoren.

Die Auswahl an Lösungsmittel/Dispergiermittel sowie an organischem Halbleiter kann entsprechend dem Zweck und dem Anwendungsgebiet erfolgen, so dass ein möglichst optimales Beschichtungs- vorzugsweise Druckergebnis erzielt wird. Das Absorptionsmaterial kann entsprechend dem gewählten Lösungsmittel/Dispergiermittel und dem ausgesuchten organischem Halbleiter ausgewählt werden, wobei das Absorptionsmaterial nicht zu einer unerwünschten Veränderung des Lösungsmittels/Dispergiermittels oder des organischen Halbleiters führen darf. Gegebenenfalls kann ein Polymermaterial als Umhüllungsmaterial, wie zuvor beschrieben, eingesetzt werden, das zwar für die Verunreinigungen durchlässig ist, jedoch den organischen Halbleiter von dem Absorptionsmaterial trennt.

Ferner kann vorgesehen sein, dass das Gewichtsverhältnis von Absorptionsmaterial zu Formulierung im Bereich von 1:1 bis 1:1000, vorzugsweise im Bereich von 1:5 bis 1:500, besonders bevorzugt im Bereich von 1:10 bis 1:100 liegt.

Ein weiterer Gegenstand der vorliegenden Erfindung ist die Verwendung einer Druckerkartusche gemäß der vorliegenden Erfindung zur Herstellung einer elektronischen Vorrichtung.

Unter einer elektronischen Vorrichtung wird eine Vorrichtung verstanden, welche Anode, Kathode und mindestens eine dazwischenliegenden Funktionsschicht enthält, wobei diese Funktionsschicht mindestens eine organische bzw. metallorganische Verbindung enthält.

Die organische, elektronische Vorrichtung ist vorzugsweise eine organische elektrolumineszierende Vorrichtung (OLED), eine polymere elektrolumineszierende Vorrichtung (PLED), eine organische integrierte Schaltung (O-IC), ein organischer Feld-Effekt-Transistor (O-FET), ein organischer Dünnfilmtransistor (O-TFT), ein organischer, lichtemittierender Transistor (O-LET), eine organische Solarzelle (O-SC), ein organischer, optischer Detektor, ein organischer Fotorezeptor, ein organisches Feld-Quench-Device (O-FQD), ein organisch elektrischer Sensor, eine lichtemittierende elektrochemische Zelle (LEC) oder eine organische Laserdiode (O-Laser). Aktive Komponenten sind generell die organischen oder anorganischen Materialien, welche zwischen Anode und Kathode eingebracht sind, wobei diese aktiven Komponenten die Eigenschaften der elektronischen Vorrichtung, beispielsweise deren Leistungsfähigkeit und/oder deren Lebensdauer bewirken, aufrechterhalten und/oder verbessern, beispielsweise Ladungsinjektions-, Ladungstransport- oder Ladungsblockiermaterialien, insbesondere aber Emissionsmaterialien und Matrixmaterialien. Das organisch funktionelle Material, welches zur Herstellung von Funktionsschichten elektronischer Vorrichtungen einsetzbar ist, umfasst demgemäß vorzugsweise eine aktive Komponente der elektronischen Vorrichtung.

Eine bevorzugte Ausführungsform sind organische Elektrolumineszenzvorrichtungen, die durch Verwendung der erfindungsgemäßen Druckerkartuschen erhältlich sind. Die organische Elektrolumineszenzvorrichtung enthält Kathode, Anode und mindestens eine emittierende Schicht.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum.

Der Anteil des Matrixmaterials in der emittierenden Schicht liegt in diesem Fall vorzugsweise zwischen 50 und 99,9 Vol.-%, besonders bevorzugt zwischen 80 und 99,5 Vol.-% und insbesondere bevorzugt für fluoreszierende emittierende Schichten zwischen 92 und 99,5 Vol.-% sowie für phosphoreszierende emittierende Schichten zwischen 85 und 97 Vol.-%.

Entsprechend liegt der Anteil des Dotanden vorzugsweise zwischen 0,1 und 50 Vol.-%, besonders bevorzugt zwischen 0,5 und 20 Vol.-% und insbesondere bevorzugt für fluoreszierende emittierende Schichten zwischen 0,5 und 8 Vol.-% sowie für phosphoreszierende emittierende Schichten zwischen 3 und 15 Vol.-%.

Eine emittierende Schicht einer organischen Elektrolumineszenzvorrichtung kann auch Systeme umfassen, die mehrere Matrixmaterialien (Mixed-Matrix-Systeme) und/oder mehrere Dotanden enthalten. Auch in diesem Fall sind die Dotanden im Allgemeinen diejenigen Materialien, deren Anteil im System der kleinere ist und die Matrixmaterialien sind diejenigen Materialien, deren Anteil im System der größere ist. In Einzelfällen kann jedoch der Anteil eines einzelnen Matrixmaterials im System kleiner sein als der Anteil eines einzelnen Dotanden.

Die Mixed-Matrix-Systeme umfassen bevorzugt zwei oder drei verschiedene Matrixmaterialien, besonders bevorzugt zwei verschiedene Matrixmaterialien. Bevorzugt stellt dabei eines der beiden Materialien ein Material mit lochtransportierenden Eigenschaften und das andere Material ein Material mit elektronentransportierenden Eigenschaften dar. Die gewünschten elektronentransportierenden und lochtransportierenden Eigenschaften der Mixed-Matrix-Komponenten können jedoch auch hauptsächlich oder vollständig in einer einzigen Mixed-Matrix-Komponente vereinigt sein, wobei die weitere bzw. die weiteren Mixed-Matrix-Komponenten andere Funktionen erfüllen. Die beiden unterschiedlichen Matrixmaterialien können dabei in einem Verhältnis von 1:50 bis 1:1, bevorzugt von 1:20 bis 1:1, besonders bevorzugt von 1:10 bis 1:1 und insbesondere bevorzugt von 1:4 bis 1:1 vorliegen. Bevorzugt werden Mixed-Matrix-Systeme in phosphoreszierenden organischen Elektrolumineszenzvorrichtungen eingesetzt. Detailliertere Angaben zu

Mixed-Matrix-Systemen finden sich z.B. in der WO 2010/108579.

Außer diesen Schichten kann eine organische Elektrolumineszenzvorrichtung noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten (Charge-Generation Layers, IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer) und/oder organische oder anorganische p/n-Übergänge. Dabei ist es möglich, dass eine oder mehrere Lochtransportschichten p-dotiert sind, beispielsweise mit Metalloxiden, wie $MoO_3$ oder $WO_3$ oder mit (per)fluorierten elektronenarmen Aromaten, und/oder dass eine oder mehrere Elektronentransportschichten n-dotiert sind. Ebenso können zwischen zwei emittierende Schichten Interlayer eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss. Diese Schichten können ebenfalls unter Verwendung der erfindungsgemäß einsetzbaren Formulierungen, wie oben definiert, erhalten werden.

Ferner kann vorgesehen sind, dass eine oder mehrere Schichten einer elektronischen Vorrichtung aus Lösung, wie z.B. durch Spincoating, oder mit einem beliebigen Druckverfahren, wie z.B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Demgemäß kann die vorliegende Druckerkartusche vorzugsweise so ausgestaltet werden, dass die entsprechende Beschichtungsvorrichtung mit der Formulierung beschickt werden kann.

Die Vorrichtung wird in an sich bekannter Weise je nach Anwendung entsprechend strukturiert, kontaktiert und schließlich hermetisch versiegelt, da sich die Lebensdauer derartiger Vorrichtungen bei Anwesenheit von Wasser und/oder Luft drastisch verkürzt.

Die erfindungsgemäßen Druckerkartuschen zeichnen sich durch einen oder mehrere der folgenden überraschenden Vorteile gegenüber dem Stand der Technik aus:

1. Die mit den erfindungsgemäßen Druckerkartuschen erhältlichen elektronischen Vorrichtungen zeigen eine sehr hohe Stabilität und eine sehr hohe Lebensdauer und eine ausgezeichnete Qualität im Vergleich zu elektronischen Vorrichtungen, die mit konventionellen Druckkartuschen erhalten werden, wobei die Eigenschaften auch nach einer längeren Lagerungs- oder Transportzeit der Druckerkartusche erzielt werden können.

2. Die erfindungsgemäßen Druckerkartuschen können an konventionelle Druckern angepasst und mit diesen verarbeitet werden, so dass auch hierdurch Kostenvorteile erzielt werden können.

3. Die erfindungsgemäßen Druckerkartuschen ermöglichen einen sicheren und zuverlässigen Transport von Formulierungen, die auch zur Herstellung von sehr feinstrukturierten elektronischen Vorrichtungen verwendet werden können.

4. Die Druckerkartuschen der vorliegenden Erfindung können kostengünstig hergestellt auf bekannten Maschinen werden, wobei keine oder nur geringfügige Adaptionen notwendig sind.

Diese oben genannten Vorteile gehen nicht mit einer Verschlechterung der weiteren elektronischen Eigenschaften einher.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbarte Merkmal, sofern nichts anderes gesagt wird, als Beispiel einer generischen Reihe oder als äquivalentes oder ähnliches Merkmal zu betrachten.

Alle Merkmale der vorliegenden Erfindung können in jeder Art miteinander kombiniert werden, es sei denn, dass sich bestimmte Merkmale und/oder Schritte gegenseitig ausschließen. Dies gilt insbesondere für bevorzugte Merkmale der vorliegenden Erfindung. Gleichermaßen können Merkmale nicht wesentlicher Kombinationen separat verwendet werden (und nicht in Kombination).

Es sei ferner darauf hingewiesen, dass viele der Merkmale, und insbesondere die der bevorzugten Ausführungsformen der vorliegenden Erfindung selbst erfinderisch und nicht lediglich als Teil der Ausführungsformen der vorliegenden Erfindung zu betrachten sind. Für diese Merkmale kann ein unabhängiger Schutz zusätzlich oder alternativ zu jeder gegenwärtig beanspruchten Erfindung begehrt werden.

Die mit der vorliegenden Erfindung offengelegte Lehre zum technischen Handeln kann abstrahiert und mit anderen Beispielen kombiniert werden.

Die vorliegende Erfindung wird im folgenden anhand von Ausführungsbeispielen näher beschrieben, ohne

dadurch jedoch beschränkt zu werden.

**Beispiel 1**

Modifizierte Printerkartusche für das Drucken von OLED Materialien:

Für den Druck von OLED-Bauteilen wird eine Tintenstrahltechnologie eingesetzt. Für den Druck der einzelnen Schichten des gewünschten Bauteils wird ein kommerziell erhältlicher industrieller Tintenstrahldrucker von Dimatix verwendet. Die Tintenzuführung erfolgt unter Verwendung von industrieüblichen Druckerkartuschen. Die verwendeten Kartuschen bestehen aus einem Kunststoff-Außenbehälter, in dem ein Mehrlagenfolienbeutel eingebettet ist, der die Drucktinte enthält. Der Mehrlagenfolienbeutel besteht aus einer innenliegenden Polyethylenfolie mit einer Dicke von 100 Mikrometern, auf die eine dünne Aluminiumschicht von 15 Mikrometern aufgetragen ist und einer außenliegenden PET-Folie mit 40 Mikrometer Schichtdicke sowie Zwischenschichten um die Folien zu verbinden. Über ein Ventil in dem Folienbeutel kann die Tinte eingefüllt und zum Betrieb des Druckers entnommen werden. Die industrieüblich erhältlichen Druckerkartuschen sind optimiert für die Benutzung von wasserbasierenden Farbtinten und damit nicht ausreichend, um die Qualität der empfindlichen, in organischen Lösungsmitteln gelösten Materialien für die Herstellung von OLED-Bauteilen sicherzustellen.

Erfindungsgemäß wird die Druckerkartusche in folgender Weise verändert. Bei der Herstellung des im Inneren der Druckerkartusche befindlichen Mehrlagenfolienbeutels wird ein Metallstreifen aus Calcium oder Lithium oder eine Kombination von beiden eingearbeitet. In der bevorzugten Ausführung wird ein Calcium-Metallstreifen von 50 $\mu$m Dicke und 2 cm Breite zwischen der Aluminiumschicht und der innenliegenden PE-Folie des Innenbeutels der Kartusche in trockener Atmosphäre einlaminiert. Aus der derartig aufbereiteten Folie wird dann der Folienbeutel gefertigt, in der Weise, das der Calciumstreifen mit der darauf liegenden PE-Folie zur Innenseite des Folienbeutels gerichtet ist. Der verwendete Folienbeutel hatte ein Füllvolumen von 100 Milliliter. Dieser Folienbeutel wird dann in der üblichen Weise mit dem Ventil versehen und in die Printerkartusche eingebaut und mit Tinte gefüllt.

Mit der so modifizierten Kartusche gefüllt mit einer Tintenmischung wurden Lagertests im Vergleich zur Lagerung in einer unmodifizierten Kartusche durchgeführt. Dafür eingesetzt wurden zwei Tintenmischungen, die für die Herstellung von OLED Bauteilen benutzt werden (MHL3-0119 und MBL3-6620 der Firma Merck). Die Lagerung erfolgte bei Raumtemperatur für 14 Monate.

Folgende Ergebnisse im Vergleich zu den Ausgangswerten wurden erreicht:

| Tintenmischung | Kartusche/Lagerung | Sauerstoffgehalt | Wassergehalt |
|---|---|---|---|
| MHL3-0119 | nach Herstellung | 100% | 100% |
| | 14 Monate, nicht modifizierte Kartusche | 150% | 204% |
| | 14 Monate, Kartusche modifiziert mit Ca-Film | 110% | 111% |
| MBL3-6620 | nach Herstellung | 100% | 100% |
| | 14 Monate, nicht modifizierte Kartusche | 250% | 166% |
| | 14 Monate, Kartusche modifiziert mit Ca-Film | 140% | 108% |

Nach Lagerung für 14 Monate bei Raumtemperatur werden in der unmodifizierten Druckerkartusche die Ausgangswerte für Sauerstoff- und Wassergehalt deutlich überschritten. Durch die erfindungsgemäße Modifikation der Kartusche fällt der Anstieg für Sauerstoff und Wassergehalt wesentlich geringer aus.

**Referenzbeispiel 2**

Modifizierte Vorratsbehälter für Tinten in der organischen Elektronik und für organische Solarzellen:

Bei der Herstellung von Bauteilen in der organischen Elektronik oder von Solarzellen haben sich Gebinde der Marke Nowpak (Entegris) bewährt. Die Gebinde sind Metallflaschen, die mit einem Inliner-Folienbeutel aus PTFE ausgestattet sind. Eine solche Flasche wird erfindungsgemäß in der Weise modifiziert, dass in den Zwischenraum zwischen der Innenwand der Metallflasche und dem Folienbeutel aus PTFE ein Absorbermaterial eingebracht wird. Die Menge des Absorbermaterials sollte etwa 1 Gew.-% der Füllmenge des Behälters betragen. Das Absorptionsmaterial wird hergestellt, in dem in trockener Atmosphäre in einer Glovebox ein kommerziell erhältliches getrocknetes Silicagel mit einem Ca-Pulver im Verhältnis 10:1 intensiv vermischt wird. Das so hergestellte Absorbermaterial wird sofort nach der

Herstellung unter trockener Atmosphäre in den Zwischenraum zwischen Metallwand und Inlinerbeutel der zu modifizierenden Flasche eingebracht. Im Beispiel wurde eine Flasche mit einem Füllvolumen von 1000 ml (Flasche der Marke Nowpak von Entegris) verwendet.

Die auf dieser Weise modifizierte Flasche wird vor der Befüllung in trockener Atmosphäre in einer Glovebox gelagert und dann in üblicher Weise mit der gewünschten Tinte befüllt und untersucht. Die so modifizierte Flasche kann dann in üblicher Weise unverändert für die Herstellung von Bauteilen der organischen Elektronik, von OLED Bauteilen oder organischen Solarzellen zum Beispiel mittels Spin-Coating verwendet werden.

Im Beispiel wurde eine Tinte bestehend aus einem Lochtransporter-Material (HTM-081, Merck) gelöst zu 5 Gramm pro Liter in Toluol verwendet. Die Mischung wurde in einer Glovebox in trockener Atmosphäre hergestellt und wies nach Herstellung einen Sauerstoffgehalt von <4 ppm und einen Wassergehalt < 200 ppm gemessen mit Karl-Fischer-Titration auf.

Nach der Befüllung der mittels Absorber modifizierten Flasche mit 1000 ml Tintenlösung wurde die Flasche zunächst für eine Woche danach für 2 Monate außerhalb der Glovebox bei Raumtemperatur gelagert. Ein Woche nach der Befüllung sank der gemessene Wassergehalt in den Proben um 10-20 % ab. Der Sauerstoffgehalt blieb unter der Messgrenze von 4 ppm. Nach der Lagerung von weiteren zwei Monaten konnte kein nachweisbarer Anstieg für Wasser- und Sauerstoffgehalt beobachtet werden.

## Referenzbeispiel 3

Lieferbehälter für das Drucken von organischen Funktionstinten und OLED Tinten

Für den Einsatz in großen Produktionsanlagen wird zur Lieferung der Tinten ein Edelstahlbehälter mit einem Behältervolumen von 1 bis 200 Liter oder auch größer verwendet. Als Beispiel wird ein 30 Liter Edelstahlbehälter verwendet. Der Behälter hat einen Deckel, der mit einer Dichtung mit dem Behälter verschraubt ist. In diesen Deckel sind neben einem Sicherheitsventil und gegebenenfalls Messeinrichtungen zwei Rohrdurchführungen mit einem Durchmesser von im Beispiel jeweils 10 mm bestückt mit Edelstahlrohren angebracht. Ein Rohr reicht bis kurz über den Boden des Behälters und dient zur Entnahme der Flüssigkeit aus dem Behälter. Das zweite Rohr endet kurz unterhalb des Deckels und erlaubt die Befüllung des Behälters. Die beiden Rohre sind oberhalb des Deckels jeweils mit einem Ventil verschlossen und mit Anschlüssen ausgestattet, die an die üblichen Füll-oder Entnahmeeinrichtungen angeschlossen werden können. Erfindungsgemäß wird in diesen Lieferbehälter ein Absorbermaterial eingebracht. Das Absorbermaterial wird im Beispiel 3a) in einen porösen PTFE-Beutel gefüllt. Die maximale Porengröße des für den Beutel verwendeten PTFE soll 100 nm betragen. Der Beutel wird in trockener Atmosphäre mit dem Absorbermaterial gefüllt, verschlossen und nach der Reinigung und Trocknung des Lieferbehälters in trockenem Zustand in den Behälter eingelegt, bevor der Deckel des Behälters mit den Befüll- und Entnahmerohr montiert wird. Danach wird die Tinte eingefüllt und kommt damit in direkten Kontakt mit dem Beutel mit dem Arbsorbermaterial und kann diesen auch auf Grund der Porosität durchdringen. Damit kommt das Absorbermaterial in direkten Kontakt mit der befüllten Drucktinte.

Im Beispiel 3b) wird das Absorbermaterial in anderer Weise eingebracht. Das Absorbermaterial wird in ein Edelstahlrohr eingefüllt, das nach der Füllung auf beiden Seiten mit einem Membranfilter verschlossen wird. Das Rohr mit dem Absorbermaterial wird im trockenen Zustand innerhalb des Behälters mit dem Einfüllrohr verbunden, so dass die Tinte während der Befüllung zunächst über das Einfüllrohr und den ersten der beiden Membranfilter in das Rohr mit dem Absorbermaterial strömt, um danach über den zweiten Filter in das verbleibende innere Volumen des Behälters zu gelangen. Während der Befüllung wird das Rohr mit dem Absorbermaterial von der eingefüllten Tinte vollständig umspült und bleibt während der Lagerung und dem Transport mit der Tinte im Kontakt. Als Membranfilter werden kommerziell erhältliche Membranfilter der Firma Entegris verwendet. Als Absorbermaterial findet Aluminiumoxid, reinst Verwendung, beispielsweise in einer Menge von 8 Gew.-% bezogen auf die Füllmenge des Behälters. Der Behälter wird mit einer Lochleitertinte, wie sie für die Herstellung von OLED Devices oder auch für Bauteile der organischen Elektronik verwendet wird, befüllt. Im Beispiel kam eine Tinte der Bezeichnung MHL3-0119 der Firma Merck zum Einsatz. Nach Vorbereitung der Behälter wie im Beispiel 3a) und 3b) beschrieben, wurden die Behälter mit jeweils 30 Liter der Tinte befüllt.

Nach der Befüllung und nach einer Lagerzeit von 2 Monaten wurde der Wassergehalt der Tinte bestimmt und mit dem Ausgangswert verglichen. Folgende Ergebnisse wurden erzielt.

| Lagerzeit | Wassergehalt im Behälter gemäß Beispiel 3a) | Wassergehalt im Behälter gemäß Beispiel 3b) |
|---|---|---|
| Vor Befüllung | 120 ppm | 120 ppm |
| Unmittelbar nach Befüllung | Nicht bestimmt | 40 ppm |

(fortgesetzt)

| Lagerzeit | Wassergehalt im Behälter gemäß Beispiel 3a) | Wassergehalt im Behälter gemäß Beispiel 3b) |
|---|---|---|
| Eine Woche nach der Befüllung | 52 ppm | Nicht bestimmt |
| Nach 2 Monaten Lagerzeit | 60 ppm | 57 ppm |

Nach längerer Lagerzeit bis zu 6 Monaten wurde kein signifikanter Anstieg des Wassergehaltes über die Messgenauigkeit der verwendeten Karl-Fischer-Messmethode hinaus beobachtet.

**Patentansprüche**

1. Druckerkartusche umfassend eine Formulierung enthaltend einen oder mehrere organische Halbleiter gelöst oder dispergiert in einem organischen Lösungsmittel oder Dispergiermittel, wobei die Formulierung mit mindestens einem Absorptionsmaterial in Kontakt steht und das Absorptionsmaterial Sauerstoff, Wasser, Kohlendioxid und/oder Hydroxidionen binden oder mit diesen Stoffen reagieren kann, **dadurch gekennzeichnet, dass** die Druckerkartusche ein Gehäuse aufweist, in das ein Innenbeutel eingebracht ist, in welchem sich die Formulierung, enthaltend mindestens einen organischen Halbleiter, befindet.

2. Druckerkartusche gemäß Anspruch 1, **dadurch gekennzeichnet, dass** das Absorptionsmaterial ausgewählt ist aus Alkali- oder Erdalkalimetallen, wie z.B. Ca, Ba, Sr, Mg, Li, Na und K, oder deren Oxide; Aluminium-, Titan- oder Zirconiumoxid, Siliciumoxid, Zeolithe, Silicagele oder Alumino-Silikate; Übergangsmetalle, vorzugsweise Zirconium, Vanadium, Cobalt, Eisen, Mangan, Kupfer und Zink, oder deren Oxide sowie Kombinationen, Mischungen oder Legierungen aus diesen Materialien, wie z.B. Silicagele, die mit Alkali- oder Erdalkalimetallen angereichert sind.

3. Druckerkartusche gemäß Anspruch 1 oder 2, **dadurch gekennzeichnet, dass** das Absorptionsmaterial in Form einer Folie, eines Pulvers, eines Granulats, vorzugsweise mit Korngrößen im Bereich von 1 μm bis 5 mm, besonders bevorzugt 100 μm bis 1 mm, und/oder eines Formkörpers, vorzugsweise einer Tablette vorliegt.

4. Druckerkartusche gemäß mindestens einem der vorhergehenden Ansprüche, **dadurch gekennzeichnet, dass** das Absorptionsmaterial porös oder partikulär ist.

5. Druckerkartusche gemäß mindestens einem der vorhergehenden Ansprüche, **dadurch gekennzeichnet, dass** das Absorptionsmaterial unmittelbar mit der Formulierung in Kontakt steht.

6. Druckerkartusche gemäß mindestens einem der vorhergehenden Ansprüche 1 bis 4, **dadurch gekennzeichnet, dass** das Absorptionsmaterial in ein Polymermaterial, vorzugsweise einem Polymerfilm oder eine Polymerbeschichtung eingebettet ist.

7. Druckerkartusche gemäß Anspruch 6, **dadurch gekennzeichnet, dass** der Polymerfilm das Absorptionsmaterial umgibt, so dass der Polymerfilm einen Beutel, einen Behälter oder eine Umhüllung bildet, in welchem das Absorptionsmaterial enthalten ist.

8. Druckerkartusche gemäß Anspruch 6, **dadurch gekennzeichnet, dass** das Polymermaterial oder der Polymerfilm das Absorptions-material enthält, so dass eine Mischung aus Polymermaterial und Absorptionsmaterial vorliegt und bevorzugt das Absorptionsmaterial homogen in dem Polymerfilm oder dem Polymermaterial verteilt ist.

9. Druckerkartusche gemäß mindestens einem der vorher-gehenden Ansprüche 6 bis 8, **dadurch gekennzeichnet, dass** das Polymermaterial, vorzugsweise der Polymerfilm eine Durchlässigkeit gegenüber Sauerstoff, Wasser, Kohlendioxid und/oder Hydroxidionen von mindestens 0,001 g/($m^2$ d) (Gramm pro Quadratmeter und Tag) aufweist, gemessen mittels Diffusionsmessung.

10. Druckerkartusche gemäß mindestens einem der vorhergehenden Ansprüche 6 bis 9, **dadurch gekennzeichnet, dass** das Gewichtsverhältnis von Absorptionsmaterial zu Polymermaterial, vorzugsweise Polymerfilm im Bereich

von 500:1 bis 1:500, vorzugsweise 100:1 bis 1:100, speziell bevorzugt 10:1 bis 1:10 ist.

11. Druckerkartusche gemäß Anspruch 1, **dadurch gekennzeichnet, dass** der Innenbeutel aus einer Mehrschichtfolie aufgebaut ist, die gegenüber Sauerstoff, Wasser, Kohlendioxid und/oder Hydroxidionen undurchlässig ist.

12. Druckerkartusche gemäß mindestens einem der vorhergehenden Ansprüche 1 bis 11, **dadurch gekennzeichnet, dass** zumindest auf einen Teil der inneren Oberfläche des Innenbeutels eine Schicht mit einem Absorptionsmaterial aufgebracht und/oder das Absorptionsmaterial in eine Innenschicht des Innenbeutels eingebracht ist.

13. Druckerkartusche gemäß mindestens einem der vorher-gehenden Ansprüche 1 bis 12, **dadurch gekennzeichnet, dass** die Druckerkartusche ein Ventil aufweist, wobei das Absorptionsmaterial in der Nähe des Ventils fixiert ist, vorzugsweise in einen Polymerfilm, einen Beutel, einen Behälter oder eine Umhüllung eingebracht, der bzw. die mit dem Ventil verbunden ist, vorzugsweise verschweißt ist.

14. Druckerkartusche gemäß mindestens einem der vorhergehenden Ansprüche, **dadurch gekennzeichnet, dass** der organische Halbleiter ausgewählt ist aus Host-Materialien, Matrix-Materialien, Elektronentransportmaterialien, Elektroneninjektionsmaterialien, Lochleitermaterialien, Lochinjektionsmaterialien, Elektronenblockiermaterialien und Lochblockiermaterialien.

15. Verwendung einer Druckerkartusche gemäß mindestens einem der vorhergehenden Ansprüche 1 bis 14 zur Herstellung einer elektronischen Vorrichtung, wobei die elektronische Vorrichtung eine organische elektrolumineszierende Vorrichtung (OLED), eine polymere elektrolumineszierende Vorrichtung (PLED), eine organische integrierte Schaltung (O-IC), ein organischer Feld-Effekt-Transistor (O-FET), ein organischer Dünnfilmtransistor (O-TFT), ein organischer, lichtemittierender Transistor (O-LET), eine organische Solarzelle (O-SC), ein organischer, optischer Detektor, ein organischer Fotorezeptor, ein organisches Feld-Quench-Device (O-FQD), ein organisch elektrischer Sensor, eine lichtemittierende elektrochemische Zelle (LEC) oder eine organische Laserdiode (O-Laser) ist.

**Claims**

1. Printer cartridge containing a formulation comprising one or more organic semiconductors dissolved or dispersed in an organic solvent or dispersion medium, where the formulation is in contact with at least one absorption material and the absorption material is able to bind oxygen, water, carbon dioxide and/or hydroxide ions or react with these substances, **characterised in that** the printer cartridge has a casing into which an internal pouch containing the formulation comprising at least one organic semiconductor has been introduced.

2. Printer cartridge according to Claim 1, **characterised in that** the absorption material is selected from alkali metals or alkaline-earth metals, such as, for example, Ca, Ba, Sr, Mg, Li, Na and K, or oxides thereof; aluminium oxide, titanium oxide or zirconium oxide, silicon oxide, zeolites, silica gels or aluminosilicates; transition metals, preferably zirconium, vanadium, cobalt, iron, manganese, copper and zinc, or oxides thereof, and combinations, mixtures or alloys of these materials, such as, for example, silica gels which have been enriched with alkali metals or alkaline-earth metals.

3. Printer cartridge according to Claim 1 or 2, **characterised in that** the absorption material is in the form of a film, powder, granular material, preferably having particle sizes in the range from 1 μm to 5 mm, particularly preferably 100 μm to 1 mm, and/or moulding, preferably a tablet.

4. Printer cartridge according to at least one of the preceding claims, **characterised in that** the absorption material is porous or particulate.

5. Printer cartridge according to at least one of the preceding claims, **characterised in that** the absorption material is in direct contact with the formulation.

6. Printer cartridge according to at least one of the preceding Claims 1 to 4, **characterised in that** the absorption material is embedded in a polymer material, preferably a polymer film or a polymer coating.

7. Printer cartridge according to Claim 6, **characterised in that** the polymer film surrounds the absorption material, so that the polymer film forms a pouch, container or jacket which contains the absorption material.

**8.** Printer cartridge according to Claim 6, **characterised in that** the polymer material or polymer film contains the absorption material in such a way that a mixture of polymer material and absorption material is present and the absorption material is preferably homogeneously distributed in the polymer film or polymer material.

**9.** Printer cartridge according to at least one of the preceding Claims 6 to 8, **characterised in that** the polymer material, preferably the polymer film, has a permeability for oxygen, water, carbon dioxide and/or hydroxide ions of at least 0.001 g/($m^2$ d) (grams per square metre and day), measured by means of diffusion measurement.

**10.** Printer cartridge according to at least one of the preceding Claims 6 to 9, **characterised in that** the weight ratio of absorption material to polymer material, preferably polymer film, is in the range from 500:1 to 1:500, preferably 100:1 to 1:100, especially preferably 10:1 to 1:10.

**11.** Printer cartridge according to Claim 1, **characterised in that** the internal pouch is built up from a multilayer film which is impermeable to oxygen, water, carbon dioxide and/or hydroxide ions.

**12.** Printer cartridge according to at least one of the preceding Claims 1 to 11, **characterised in that** a layer comprising an absorption material has been applied at least to part of the inside surface of the internal pouch and/or the absorption material has been introduced into an inner layer of the internal pouch.

**13.** Printer cartridge according to at least one of the preceding Claims 1 to 12, **characterised in that** the printer cartridge has a valve, where the absorption material is fixed in the vicinity of the valve, preferably has been introduced into a polymer film, pouch, container or jacket which is bonded, preferably welded, to the valve.

**14.** Printer cartridge according to at least one of the preceding claims, **characterised in that** the organic semiconductor is selected from host materials, matrix materials, electron-transport materials, electron-injection materials, hole-conductor materials, hole-injection materials, electron-blocking materials and hole-blocking materials.

**15.** Use of a printer cartridge according to at least one of the preceding Claims 1 to 14 for the production of an electronic device, where the electronic device is an organic electroluminescent device (OLED), a polymeric electroluminescent device (PLED), an organic integrated circuit (O-IC), an organic field-effect transistor (O-FET), an organic thin-film transistor (O-TFT), an organic, light-emitting transistor (O-LET), an organic solar cell (O-SC), an organic optical detector, an organic photoreceptor, an organic field-quench device (O-FQD), an organic electric sensor, a light-emitting electrochemical cell (LEC) or an organic laser diode (O-laser).

## Revendications

**1.** Cartouche d'imprimante contenant une formulation qui comprend un ou plusieurs semiconducteur(s) organique(s) qui est/sont dissous ou dispersé(s) dans un solvant ou un milieu de dispersion organique, dans laquelle la formulation est en contact avec au moins un matériau d'absorption et le matériau d'absorption dispose de la capacité de se lier avec l'oxygène, l'eau, le dioxyde de carbone et / ou les ions hydroxyde ou de réagir avec ces substances, **caractérisée en ce que** la cartouche d'imprimante comporte un carter à l'intérieur duquel une poche interne qui contient la formulation qui comprend au moins un semiconducteur organique a été introduite.

**2.** Cartouche d'imprimante selon la revendication 1, **caractérisée en ce que** le matériau d'absorption est sélectionné parmi les métaux alcalins ou les métaux alcalino-terreux, tels que, par exemple, Ca, Ba, Sr, Mg, Li, Na et K, ou leurs oxydes ; l'oxyde d'aluminium, l'oxyde de titane, l'oxyde de zirconium, l'oxyde de silicium, les zéolites, les gels de silice ou les aluminosilicates ; les métaux de transition, de préférence le zirconium, le vanadium, le cobalt, le fer, le manganèse, le cuivre et le zinc, ou leurs oxydes, et des combinaisons, des mélanges ou des alliages de ces matériaux, tels que, par exemple, les gels de silice qui ont été enrichis à l'aide de métaux alcalins ou de métaux alcalino-terreux.

**3.** Cartouche d'imprimante selon la revendication 1 ou 2, **caractérisée en ce que** le matériau d'absorption est sous la forme d'un film, d'une poudre, d'un matériau granulaire, de préférence qui présente des dimensions de particule dans la plage qui va de 1 $\mu$m à 5 mm, de façon particulièrement préférable de 100 $\mu$m à 1 mm, et/ou d'un moulage, de préférence une pastille.

**4.** Cartouche d'imprimante selon au moins l'une des revendications précédentes, **caractérisée en ce que** le matériau

d'absorption est poreux ou particulaire.

5. Cartouche d'imprimante selon au moins l'une des revendications précédentes, **caractérisée en ce que** le matériau d'absorption est en contact direct avec la formulation.

6. Cartouche d'imprimante selon au moins l'une des revendications précédentes 1 à 4, **caractérisée en ce que** le matériau d'absorption est intégré dans un matériau de polymère, de préférence en film en polymère ou un revêtement en polymère.

7. Cartouche d'imprimante selon la revendication 6, **caractérisée en ce que** le film en polymère entoure le matériau d'absorption, de telle sorte que le film en polymère forme une poche, un contenant ou une gaine à fonction d'enveloppe qui contient le matériau d'absorption.

8. Cartouche d'imprimante selon la revendication 6, **caractérisée en ce que** le matériau de polymère ou le film en polymère contient le matériau d'absorption de telle sorte qu'un mélange de matériau de polymère et de matériau d'absorption soit présent et que le matériau d'absorption soit de préférence distribué de façon homogène dans le film en polymère ou le matériau de polymère.

9. Cartouche d'imprimante selon au moins l'une des revendications précédentes 6 à 8, **caractérisée en ce que** le matériau de polymère, de préférence le film en polymère, présente une perméabilité vis-à-vis de l'oxygène, de l'eau, du dioxyde de carbone et / ou des ions hydroxyde d'au moins 0,001 g/($m^2$ d) (grammes par mètre carré et jour), mesurée au moyen d'une mesure par diffusion.

10. Cartouche d'imprimante selon au moins l'une des revendications précédentes 6 à 9, **caractérisée en ce que** le rapport en poids du matériau d'absorption sur le matériau de polymère, de préférence le film en polymère, s'inscrit dans la plage qui va de 500:1 à 1:500, de préférence de 100:1 à 1:100, de façon particulièrement préférable de 10:1 à 1:10.

11. Cartouche d'imprimante selon la revendication 1, **caractérisée en ce que** la poche interne est constituée à partir d'un film multicouche qui est imperméable à l'oxygène, à l'eau, au dioxyde de carbone et / ou aux ions hydroxyde.

12. Cartouche d'imprimante selon au moins l'une des revendications précédentes 1 à 11, **caractérisée en ce qu'**une couche qui comprend un matériau d'absorption a été appliquée au moins sur une partie de la surface intérieure de la poche interne et/ou le matériau d'absorption a été introduit à l'intérieur d'une couche interne de la poche interne.

13. Cartouche d'imprimante selon au moins l'une des revendications précédentes 1 à 12, **caractérisée en ce que** la cartouche d'imprimante comporte une soupape, dans laquelle le matériau d'absorption est fixé au voisinage de la soupape, de préférence, il a été introduit à l'intérieur d'un film en polymère, d'une poche, d'un contenant ou d'une gaine à fonction d'enveloppe qui est lié(e), de préférence soudé(e), à la soupape.

14. Cartouche d'imprimante selon au moins l'une des revendications précédentes, **caractérisée en ce que** le semiconducteur organique est sélectionné parmi les matériaux hôtes, les matériaux de matrice, les matériaux de transport d'électrons, les matériaux d'injection d'électrons, les matériaux conducteurs de trous, les matériaux d'injection de trous, les matériaux de blocage d'électrons et les matériaux de blocage de trous.

15. Utilisation d'une cartouche d'imprimante selon au moins l'une des revendications 1 à 14 pour la fabrication d'un dispositif électronique, dans laquelle le dispositif électronique est un dispositif électroluminescent organique (OLED), un dispositif électroluminescent polymérique (PLED), un circuit intégré organique (O-IC), un transistor à effet de champ organique (O-FET), un transistor à film mince organique (O-TFT), un transistor à émission de lumière organique (O-LET), une cellule solaire organique (O-SC), un détecteur optique organique, un photorécepteur organique, un dispositif à extinction de champ organique (O-FQD), un capteur électrique organique, une cellule électrochimique à émission de lumière (LEC) ou une diode laser organique (O-laser).

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- JP 2004149765 A
- US 3615404 A
- US 3567450 A
- US 3526501 A
- JP 56046234 A
- EP 1009041 A
- US 3615402 A
- JP 54110837 A
- US 3717462 A
- JP 61210363 A
- US 4950950 A
- JP 2204996 A
- JP 2282263 A
- JP HEISEI11989211399 B
- JP 632956965 A
- US 4720432 A
- US 4127412 A
- JP HEISEI81996193191 B
- US 3180730 A
- US 3658520 A
- US 20080102311 A1
- US 5061569 A
- JP 4308688 A
- US 20070092755 A1
- EP 1162193 B1
- EP 650955 B1
- DE 19646119 A1
- WO 2006122630 A1
- EP 1860097 A1
- EP 1834945 A1
- JP 08053397 A
- US 6251531 B1
- US 20050221124 A
- JP 08292586 A
- US 7399537 B2
- US 20060061265 A1
- EP 1661888 A
- WO 2009041635 A
- EP 0891121 A1
- EP 1029909 A1
- US 20040174116 A1
- US 5529853 A
- US 4356429 A
- US 4539507 A
- US 20070273272 A1
- US 5766779 A
- DE 102008064200
- JP 2003 A
- JP 115387 A
- JP 2004311184 A
- JP 2001267080 A
- WO 02043449 A
- EP 1480280 A
- EP 1478032 A
- EP 1469533 A
- US 20070087219 A1
- JP 2004200162 A
- US 20070252517 A1
- US 20070122656 A1
- US 20080193796 A1
- US 2006147747 A
- EP 1551206 A1
- WO 02068435 A1
- WO 02081488 A1
- EP 1239526 A2
- WO 2004026886 A2
- WO 2006122630 A
- WO 2008006449 A
- WO 2007140847 A
- WO 2006000388 A
- WO 2006058737 A
- WO 2006000389 A
- WO 2007065549 A
- WO 2007115610 A
- US 5121029 A
- US 7250532 B2
- DE 102005058557 A1
- CN 1583691 A
- JP 8053397 A
- EP 1957606 A1
- US 20080113101 A1
- US 2006210830 A
- DE 102008035413
- DE 102009005746
- US 4769292 A
- US 6020078 A
- US 20060222886 A1
- US 5130603 A
- US 20070092753 A1
- WO 0070655 A
- WO 0141512 A
- WO 0202714 A
- WO 0215645 A
- EP 1191613 A
- EP 1191612 A
- EP 1191614 A
- WO 2005033244 A
- US 20090061681 A1

- US 20010053462 A1
- US 6824895 B
- US 10729238 B
- US 6835469 B
- US 6830828 B
- US 7378162 B2
- US 6835469 B2
- JP 2003253145 A
- US 7238437 B2
- US 2009008607 A1
- EP 1348711 A
- WO 2011076314 A1
- EP 676461 A
- WO 2009069566 A
- WO 2004081017 A
- WO 2004058911 A
- WO 2005084081 A
- WO 2005084082 A
- WO 2006048268 A
- WO 2006117052 A
- WO 2008145239 A
- US 20030027016 A1
- US 7326371 B2
- US 2006043858 A
- WO 2007114358 A
- JP 3148176 B
- EP 1009044 A
- US 2004018383 A
- WO 2005061656 A1
- EP 0681019 B1
- WO 2004013073 A1
- US 5077142 A
- WO 2007065678 A
- WO 2005039246 A
- US 20050069729 A
- JP 2004288381 A
- EP 1205527 A
- WO 2008086851 A
- EP 1617710 A
- EP 1617711 A
- EP 1731584 A
- JP 2005347160 A
- WO 2004093207 A
- DE 102008033943
- WO 2005003253 A
- WO 2007137725 A
- WO 2005111172 A
- DE 102008017591
- DE 102008036982
- WO 2007063754 A
- WO 2008056746 A
- DE 102009023155
- DE 102009031021
- DE 102009022858
- US 20070134514 A1
- US 20070128467 A1
- US 20050249976 A1
- US 20040209115 A
- US 20040209116 A
- EP 652273 B1
- WO 2010108579 A
- WO 2004070772 A2
- WO 2004113468 A1
- WO 2005040302 A1
- WO 2005086251 A2
- WO 2012175535 A1
- WO 2012175219 A1
- WO 2012168358 A1
- WO 2012031735 A1
- EP 1837926 A1
- WO 2007107306 A1
- EP 2452946 A1
- EP 2463927 A1
- WO 2009000237 A1
- US 2007145355 A1
- US 7294849 B
- US 20030068528 A
- US 20030175553 A1
- WO 0070655 A2
- WO 0193642 A1
- US 20030175553 A
- WO 02077060 A1
- WO 2005014689 A2
- WO 2007131582 A1
- WO 2008009343 A1
- DE 10304819 A1
- DE 10328627 A1
- DE 10349033 A1
- US 5962631 A
- WO 2006052457 A2
- WO 2006118345 A1
- WO 2003020790 A1
- WO 2005104264 A1
- WO 2004041901 A1
- WO 2004113412 A2
- WO 2006063852 A1
- WO 2005056633 A1
- EP 1344788 A1
- WO 2007043495 A1
- WO 2005033174 A1
- WO 2003099901 A1
- DE 102006003710
- DE 10343606 A1
- US 7250226 B2
- JP 2007211243 A
- JP 2007197574 A
- JP 2007059939 A
- DE 102009023154
- JP 2005108556 A
- JP 2005285661 A
- JP 2003338375 A

**In der Beschreibung aufgeführte Nicht-Patentliteratur**


- *Synth.Metals,* 1997, vol. 91 (1-3), 209
- **Y.A. LEVIN ; M.S. SKOROBOGATOVA.** *Khimiya Geterotsiklicheskikh Soedinenii,* 1967, vol. 2, 339-341
- **C.H.CHEN et al.** Recent developments in organic electroluminescent materials. *Macromol. Symp.,* 1997, vol. 125, 1-48
- Recent progress of molecular organic electroluminescent materials and devices. *Mat. Sci. and Eng. R,* 2002, vol. 39, 143-222
- **BALDO, THOMPSON et al.** *Nature,* 2000, vol. 403, 750-753
- **ADACHI et al.** *Appl. Phys. Lett.,* 2001, vol. 78, 1622-1624
- **J.KIDO et al.** *Appl. Phys. Lett.,* 1994, vol. 65, 2124
- **KIDO et al.** *Chem. Lett.,* 1990, vol. 657
- **JOHNSON et al.** *JACS,* 1983, vol. 105, 1795
- **WRIGHTON.** *JACS,* 1974, vol. 96, 998
- **MA et al.** *Synth. Metals,* 1998, vol. 94, 245
- *Inorg. Chem.,* 2001, vol. 40 (7), 1704-1711
- *JACS,* 2001, vol. 123 (18), 4304-4312
- **H. GILMAN ; E.A. ZUECH.** *Chemistry & Industry,* 1960, vol. 120
- **T. MATSUMOTO ; T. NAKADA ; J. ENDO ; K. MORI ; N. KAWAMURA ; A. YOKOI ; J. KIDO.** Charge-Generation Layers, IDMC 2003. *Multiphoton Organic EL Device Having Charge Generation Layer*